# EUROPÄISCHE PATENTSCHRIFT

(11) **EP 3 231 033 B1**
(45) Veröffentlichungstag und Bekanntmachung des Hinweises auf die Patenterteilung: **27.05.2020**
(21) Anmeldenummer: 15804123.6
(22) Anmeldetag: 02.12.2015
(51) Int. Cl.: H01M 10/48, H01M 2/20, H01R 12/00, H01M 10/42, H05K 1/02, H01M 10/0525, B60L 50/64

(54) **ZELLKONTAKTIERUNGSSYSTEM FÜR EINE ELEKTROCHEMISCHE VORRICHTUNG**
CELL CONTACTING SYSTEM FOR AN ELECTROCHEMICAL DEVICE
SYSTÈME DE MISE EN CONTACT DE CELLULES POUR DISPOSITIF ÉLECTROCHIMIQUE

(30) Priorität: 09.12.2014 DE 102014118188
(43) Veröffentlichungstag der Anmeldung: 18.10.2017
(73) Patentinhaber: ElringKlinger AG, 72581 Dettingen (DE)
(72) Erfinder: GROSHERT, Jan, 72581 Dettingen/Erms (DE); FRITZ, Wolfgang, 72555 Metzingen (DE); BERTSCH, Moritz, 72581 Dettingen/Erms (DE)
(74) Vertreter: Hoeger, Stellrecht & Partner Patentanwälte mbB
(86) Internationale Anmeldenummer: PCT/EP2015/078405
(87) Internationale Veröffentlichungsnummer: WO 2016/091689

(56) Entgegenhaltungen:
- EP-A1- 1 882 401
- EP-A2- 2 768 294
- EP-A2- 2 804 284
- DE-A1-102010 043 885
- DE-A1-102013 207 358

## Beschreibung

Die vorliegende Erfindung betrifft ein Zellkontaktierungssystem für eine elektrochemische Vorrichtung, die mehrere elektrochemische Zellen umfasst, wobei das Zellkontaktierungssystem ein Signalleitungssystem mit einer oder mehreren Signalleitungen zum elektrisch leitenden Verbinden einer Signalquelle mit einem Signalleitungsanschluss oder mit einer Überwachungseinrichtung der elektrochemischen Vorrichtung umfasst.

Ein solches Zellkontaktierungssystem dient insbesondere dazu, eine Einzelzellüberwachung der elektrochemischen Zellen der elektrochemischen Vorrichtung hinsichtlich physikalischer Messgrößen, wie beispielsweise der Spannung und der Temperatur, zu bewerkstelligen. Hierzu werden beispielsweise elektrische Potentialunterschiede gemessen und/oder Temperaturen in der Nähe der Zellterminals von elektrochemischen Zellen mittels geeigneter Temperatursensoren umfasst. Die Signalquellen oder Messstellen sind durch das Signalleitungssystem elektrisch leitend direkt mit einer Überwachungseinrichtung der elektrochemischen Vorrichtung oder mit einem Signalleitungssystem, das als Schnittstelle zu einer solchen Überwachungseinrichtung dient, verbunden.

Bei bekannten Zellkontaktierungssystemen erfordert die Anbindung der Signalquellen an den Signalleitungsanschluss einen hohen fertigungstechnischen Aufwand.

Insbesondere sind, je nach angewendetem Konzept, teilweise manuelle Fertigungsschritte sowie zusätzliche Prozessschritte notwendig, wie beispielsweise eine Beschichtung, eine Kompaktierung oder die Schaffung eines zusätzlichen Materialübergangs.

Die DE 10 2010 043885 A1 offenbart ein Zellkontaktierungssystem gemäß dem Oberbegriff von Anspruch 1.

Die DE 10 2013 207 358 A1 offenbart ein Zellkontaktierungssystem mit einem Trägerelement für eine elektrochemische Vorrichtung, welche zylindrische elektrochemische Zellen umfasst, die längs ihrer Längsachsen hintereinander angeordnet sind.

Die EP 2 804 284 A2 offenbart ein Zellkontaktierungssystem für eine elektrochemische Vorrichtung, die mehrere elektrochemische Zellen umfasst, wobei das Zellkontaktierungssystem ein Signalleitungssystem mit mehreren Signalleitungen zum elektrisch leitenden Verbinden einer Signalquelle mit einer Überwachungseinrichtung der elektrochemischen Vorrichtung umfasst, wobei das Signalleitungssystem eine flexible Leiterplatte umfasst und wobei die flexible Leiterplatte eine flexible Isolationsfolie und mehrere an der Isolationsfolie angeordnete Leiterbahnen umfasst.

Der vorliegenden Erfindung liegt die Aufgabe zugrunde, ein Zellkontaktierungssystem der eingangs genannten Art zu schaffen, welches möglichst einfach und dennoch zuverlässig und positionsgenau herstellbar ist.

Diese Aufgabe wird durch ein Zellkontaktierungssystem nach Anspruch 1 gelöst.

Vorzugsweise beträgt die Dicke der elektrisch isolierenden Isolationsfolie weniger als 0,5 mm.

Bei einer bevorzugten Ausgestaltung des erfindungsgemäßen Zellkontaktierungssystems ist vorgesehen, dass das Zellkontaktierungssystem mindestens einen Zellverbinder zum elektrisch leitenden Verbinden von Zellterminals verschiedener elektrochemischer Zellen und/oder mindestens einen Stromanschluss zum elektrisch leitenden Verbinden der elektrochemischen Vorrichtung mit einer anderen elektrochemischen Vorrichtung oder mit einem Verbraucher umfasst, wobei mindestens eine Leiterbahn einen Verbindungsabschnitt umfasst, an welchem die Leiterbahn elektrisch leitend mit einem Zellverbinder oder einem Stromanschluss verbunden ist.

Die Verbindung der Leiterbahn mit dem Zellverbinder ist vorzugsweise stoffschlüssig, beispielsweise durch Verschweißung und/oder durch Verlötung, ausgebildet.

Ein solcher Verbindungsabschnitt kann insbesondere die Form eines, vorzugsweise frei gestalteten, Schweißpads haben, welches unmittelbar mit dem Zellverbinder oder Stromanschluss oder mit einem Anschlusselement, das an dem Zellverbinder bzw. Stromanschluss festgelegt ist, verschweißt ist.

Hierdurch ist kein Lötvorgang für die Anbindung der Leiterbahn an die Signalquelle erforderlich.

Die Verschweißung kann insbesondere durch ein Ultraschallschweißverfahren, ein Reibschweißverfahren oder ein Reibrührschweißverfahren erfolgen.

Der Verbindungsabschnitt der Leiterbahn ist in die flexible Leiterplatte integriert, so dass insbesondere kein separater Positionierungsvorgang für die Positionierung des Verbindungsabschnitts relativ zu der damit zu verbindenden Signalquelle erforderlich ist, sondern die Positionierung der flexiblen Leiterplatte als Ganzes relativ zu den Signalquellen ausreicht.

Durch die Verschweißung des Verbindungsabschnitts mit der Signalquelle oder mit einem Anschlusselement, das an der Signalquelle festgelegt ist, entfällt insbesondere auch die Notwendigkeit eines Einsatzes beschichteter Bauteile.

Die Zellverbinder und die Stromanschlüsse bilden zusammen ein Stromleitungssystem des Zellkontaktierungssystems, welches das Fließen eines Leistungsstroms von und zu den elektrochemischen Zellen der elektrochemischen Vorrichtung ermöglicht.

Durch die Flexibilität und damit leichte Verformbarkeit der Leiterplatte können Bauteiltoleranzen bei der Montage des Zellkontaktierungssystems und/oder unterschiedliche Wärmedehnungen der die Signalquellen einerseits und der das Signalleitungssystem andererseits tragenden Bauteile im Betrieb der elektrochemischen Vorrichtung kompensiert werden.

Die elektrische leitende Verbindung zwischen dem Verbindungsabschnitt und dem Zellverbinder oder Stromanschluss kann in unterschiedlicher Weise ausgebildet sein.

Beispielsweise kann vorgesehen sein, dass der Verbindungsabschnitt unmittelbar an einem Grundkörper des Zellverbinders oder des Stromanschlusses, vorzugsweise stoffschlüssig, festgelegt ist.

Dabei kann der Verbindungsabschnitt insbesondere durch Verschweißung, insbesondere Ultraschallschweißung, Reibschweißung oder Reibrührschweißung, oder durch Verlötung an dem Grundkörper festgelegt sein.

Der Grundkörper des Zellverbinders oder des Stromanschlusses umfasst mindestens einen Kontaktbereich des Zellverbinders bzw. des Stromanschlusses, mit welchem der Zellverbinder bzw. der Stromanschluss an einem Zellterminal einer elektrochemischen Zelle der elektrochemischen Vorrichtung festgelegt ist.

Der Grundkörper kann auch zwei solcher Kontaktbereiche umfassen, die an den Zellterminals verschiedener elektrochemischer Zellen der elektrochemischen Vorrichtung festgelegt sind.

Um die Fügung des Verbindungsabschnitts mit dem Zellverbinder oder Stromanschluss zu ermöglichen, kann vorgesehen sein, dass der Verbindungsabschnitt über einen äußeren Rand der mindestens einen Isolationsfolie seitlich übersteht.

Alternativ oder ergänzend hierzu kann auch vorgesehen sein, dass die mindestens eine Isolationsfolie im Bereich des Verbindungsabschnitts ein Fenster aufweist, durch welches der Verbindungsabschnitt mit dem Zellverbinder oder dem Stromanschluss oder mit einem Fügewerkzeug, beispielsweise einer Sonotrode für einen Ultraschallschweißvorgang, kontaktierbar ist.

Der Verbindungsabschnitt kann einen zu dem Zellverbinder oder Stromanschluss hin vorstehenden Bereich aufweisen.

Ein solcher vorstehender Bereich kann beispielsweise in den Verbindungsabschnitt eingeprägt sein.

Alternativ oder ergänzend zu einer direkten Verbindung des Verbindungsabschnitts mit einem Grundkörper des Zellverbinders oder Stromanschlusses kann auch vorgesehen sein, dass der Verbindungsabschnitt indirekt über ein Anschlusselement elektrisch leitend mit dem Zellverbinder oder Stromanschluss verbunden ist.

Ein solches Anschlusselement kann beispielsweise als eine Anschlussfahne ausgebildet sein.

Ferner kann vorgesehen sein, dass das Anschlusselement winkelförmig ausgebildet ist.

Ein Abschnitt des Anschlusselements kann sich durch eine Durchtrittsöffnung an dem Verbindungsabschnitt hindurch erstrecken.

Alternativ oder ergänzend zu den bisher erläuterten Verbindungsmöglichkeiten kann auch vorgesehen sein, dass der Verbindungsabschnitt mittels eines Bondleiters elektrisch leitend mit dem Zellverbinder oder Stromanschluss verbunden ist.

Ein solcher Bondleiter ist vorzugsweise mittels mindestens einer Bondverbindung elektrisch leitend mit dem Verbindungsabschnitt der Leiterbahn und/oder vorzugsweise mittels mindestens einer Bondverbindung mit einem Grundkörper des Zellverbinders bzw. des Stromanschlusses elektrisch leitend verbunden.

Eine solche Bondverbindung kann insbesondere durch Ultraschallbonden hergestellt werden.

Alternativ oder ergänzend zu den vorstehend erläuterten Verbindungsverfahren kann auch vorgesehen sein, dass der Verbindungsabschnitt der Leiterbahn mittels eines Crimpelements elektrisch leitend mit dem Zellverbinder oder Stromanschluss verbunden ist.

Alle vorstehend erläuterten Methoden zum elektrisch leitenden Verbinden eines Verbindungsabschnitts mit einem Zellverbinder oder Stromanschluss können innerhalb desselben Zellkontaktierungssystems auch miteinander kombiniert werden, wobei dann verschiedene Verbindungsabschnitte des Signalleitungssystems auf unterschiedliche Weise mit dem jeweils zugeordneten Zellverbinder oder Stromanschluss elektrisch leitend verbunden sind.

Bei einer bevorzugten Ausgestaltung der Erfindung ist vorgesehen, dass die flexible Leiterplatte mindestens zwei flexible Isolationsfolien umfasst, zwischen denen mindestens eine Leiterbahn angeordnet ist.

Dabei kann vorgesehen sein, dass zwei flexible Isolationsfolien zumindest einseitig klebend ausgebildet sind und miteinander sowie mit mindestens einer Leiterbahn des Signalleitungssystems verklebt sind.

Ferner kann vorgesehen sein, dass mindestens eine flexible Leiterplatte mindestens eine Faltung aufweist. Durch eine solche Faltung kann die Außenkontur der flexiblen Leiterplatte gegenüber der Außenkontur, mit welcher die mindestens eine flexible Isolationsfolie aus einem Ausgangsmaterial herausgetrennt, beispielsweise ausgestanzt oder ausgeschnitten, worden ist, verändert werden.

Dabei kann durch eine solche Faltung der Platzbedarf der flexiblen Leiterplatte verringert werden.

Bei einer besonderen Ausgestaltung der Erfindung ist vorgesehen, dass das Signalleitungssystem einen Sensor aufweist, der an einer flexiblen Leiterplatte des Signalleitungssystems angeordnet ist und mit mindestens einer Leiterbahn der flexiblen Leiterplatte elektrisch leitend verbunden ist.

Dabei wird der Sensor vorzugsweise an einer flexiblen Leiterplatte des Signalleitungssystems angeordnet, bevor das Signalleitungssystem in dem Zellkontaktierungssystem montiert und die zu den Zellverbindern oder Stromanschlüssen des Zellkontaktierungssystems führenden Leiterbahnen elektrisch leitend mit dem jeweils zugeordneten Zellverbinder bzw. Stromanschluss verbunden werden.

Der Sensor ist somit in die flexible Leiterplatte des Signalleitungssystems integriert, wodurch ein zusätzlicher Prozessschritt des elektrisch leitenden Verbindens eines Temperatursensors mit dem Signalleitungssystem bei der Montage des Zellkontaktierungssystems eingespart werden kann.

Bei einer besonderen Ausgestaltung der Erfindung ist vorgesehen, dass das Zellkontaktierungssystem ein Trägerelement, insbesondere in Form einer Trägerplatte, umfasst, an welchem das Signalleitungssystem angeordnet ist, wobei der Sensor durch Verformung der flexiblen Leiterplatte von einer ersten Position relativ zu dem Trägerelement in eine zweite Position relativ zu dem Trägerelement bewegbar ist. Auf diese Weise ist es möglich, die Position des Sensors im Betrieb der elektrochemischen Vorrichtung bei der Montage des Zellkontaktierungssystems auszuwählen.

Das Trägerelement kann eine Durchtrittsöffnung aufweisen, durch welche sich ein den Sensor tragender Sensorabschnitt einer flexiblen Leiterplatte des Signalleitungssystems hindurch erstreckt.

Der Sensorabschnitt der flexiblen Leiterplatte umfasst vorzugsweise mindestens eine Isolationsfolie und mindestens eine an der Isolationsfolie angeordnete Leiterbahn.

Grundsätzlich kann der Sensor zur Messung beliebiger physikalischer Größen dienen.

Vorzugsweise ist vorgesehen, dass der Sensor als ein Temperatursensor ausgebildet ist.

Das Zellkontaktierungssystem umfasst ein Trägerelement, an welchem das Signalleitungssystem angeordnet ist, wobei das Trägerelement mindestens ein trägerelementseitiges Positionierelement umfasst, das mit einem signalleitungssystemseitigen Positionierelement so zusammenwirkt, dass das Signalleitungssystem in einer gewünschten Lage relativ zu dem Trägerelement und damit vorzugsweise auch relativ zu den Zellverbindern und/oder Stromanschlüssen der elektrochemischen Vorrichtung positioniert ist.

Dabei kann ein trägerelementseitiges Positionierelement als ein Positionierzapfen ausgebildet sein, der mit einem signalleitungssystemseitigen Positionierelement in Form eines Positionierloches zusammenwirkt. Grundsätzlich könnte aber auch ein trägerelementseitiges Positionierelement in Form eines Positionierloches mit einem signalleitungssystemseitigen Positionierelement in Form eines Positionierzapfens zusammenwirken.

Das Trägerelement ist auf ein Gehäuse der elektrochemischen Vorrichtung, in dem mehrere elektrochemische Zellen angeordnet sind, aufsetzbar.

Das erfindungsgemäße Zellkontaktierungssystem eignet sich insbesondere zur Verwendung mit einer elektrochemischen Vorrichtung, die als ein Akkumulator, beispielsweise als ein Lithium-Ionen-Akkumulator, ausgebildet ist.

Wenn die elektrochemische Vorrichtung als ein Akkumulator ausgebildet ist, eignet sie sich insbesondere als eine hoch belastbare Energiequelle, beispielsweise für den Antrieb von Kraftfahrzeugen.

Weitere Merkmale und Vorteile der Erfindung sind Gegenstand der nachfolgenden Beschreibung und der zeichnerischen Darstellung von Ausführungsbeispielen.

In den Zeichnungen zeigen:
- Fig. 1: eine perspektivische Darstellung eines Trägerelements eines Zellkontaktierungssystems für eine elektrochemische Vorrichtung, insbesondere ein Akkumulatormodul, eines an dem Trägerelement gehaltenen Stromleitungssystems und eines an dem Trägerelement gehaltenen Signalleitungssystems, wobei das Signalleitungssystems zwei flexible Leiterplatten umfasst, an denen jeweils mehrere Leiterbahnen angeordnet sind;
- Fig. 2: eine vergrößerte Darstellung des Bereichs I aus Fig. 1;
- Fig. 3: eine perspektivische Darstellung einer elektrochemischen Vorrichtung mit einem Gehäuse und mehreren darin angeordneten elektrochemischen Zellen, wobei das Zellkontaktierungssystem auf das Gehäuse aufsetzbar und mit Zellterminals der elektrochemischen Zellen elektrisch leitend verbindbar ist;
- Fig. 4: eine perspektivische Darstellung des Signalleitungssystems aus Fig. 1;
- Fig. 5: eine Draufsicht von oben auf das Zellkontaktierungssystem aus Fig. 1, wobei ein Abdeckelement auf das Trägerelement des Zellkontaktierungssystem aufgesetzt ist;
- Fig. 6: eine Seitenansicht des Zellkontaktierungssystems aus Fig. 5, mit der Blickrichtung in Richtung des Pfeiles 6 in Fig. 5;
- Fig. 7: eine Vorderansicht des Zellkontaktierungssystems aus den Fig. 5 und 6, mit der Blickrichtung in Richtung des Pfeiles 7 in Fig. 5;
- Fig. 8: eine vergrößerte Darstellung des Bereichs II aus Fig. 7;
- Fig. 9: eine Draufsicht von oben auf das Zellkontaktierungssystem (ohne das Trägerelement) aus Fig. 1;
- Fig. 10: einen Querschnitt durch das Zellkontaktierungssystem aus Fig. 9, längs der Linie 10 - 10 in Fig. 9;
- Fig. 11: eine vergrößerte Darstellung des Bereichs III aus Fig. 10, welche zeigt, wie ein Verbindungsabschnitt einer Leiterbahn des Signalleitungssystems direkt mit einem Grundkörper eines Zellverbinders oder Stromanschlusses des Stromleitungssystems verbunden ist;
- Fig. 12: eine der Fig. 11 entsprechende Darstellung einer elektrisch leitenden Verbindung zwischen einem Verbindungsabschnitt einer Leiterbahn und einem Zellverbinder oder Stromanschluss bei einer zweiten Ausführungsform, bei welcher der Verbindungsabschnitt über ein winkelförmiges Anschlusselement mit dem Grundkörper des Zellverbinders bzw. des Stromanschlusses verbunden ist;
- Fig. 13: eine der Fig. 11 entsprechende Darstellung einer Verbindung zwischen einer Leiterbahn und einem Zellverbinder oder Stromanschluss bei einer dritten Ausführungsform, bei welcher die Leiterbahn über Isolationsfolien der flexiblen Leiterplatter übersteht und direkt an einem Grundkörper des Zellverbinders bzw. des Stromanschlusses festgelegt ist;
- Fig. 14: eine der Fig. 11 entsprechende Darstellung der Verbindung zwischen einem Verbindungsabschnitt einer Leiterbahn und einem Zellverbinder oder Stromanschluss bei einer vierten Ausführungsform, bei welcher der Verbindungsabschnitt mittels eines Bondleiters mit einem Grundkörper des Zellverbinders bzw. des Stromanschlusses verbunden ist; und
- Fig. 15: eine der Fig. 11 entsprechende Darstellung der Verbindung zwischen einem Verbindungsabschnitt einer Leiterbahn und einem Zellverbinder oder Stromanschluss bei einer fünften Ausführungsform, bei welcher der Verbindungsabschnitt mittels eines Crimpelements mit einem Grundkörper des Zellverbinders bzw. des Stromanschlusses verbunden ist.

Gleiche oder funktional äquivalente Elemente sind in allen Figuren mit denselben Bezugszeichen bezeichnet.

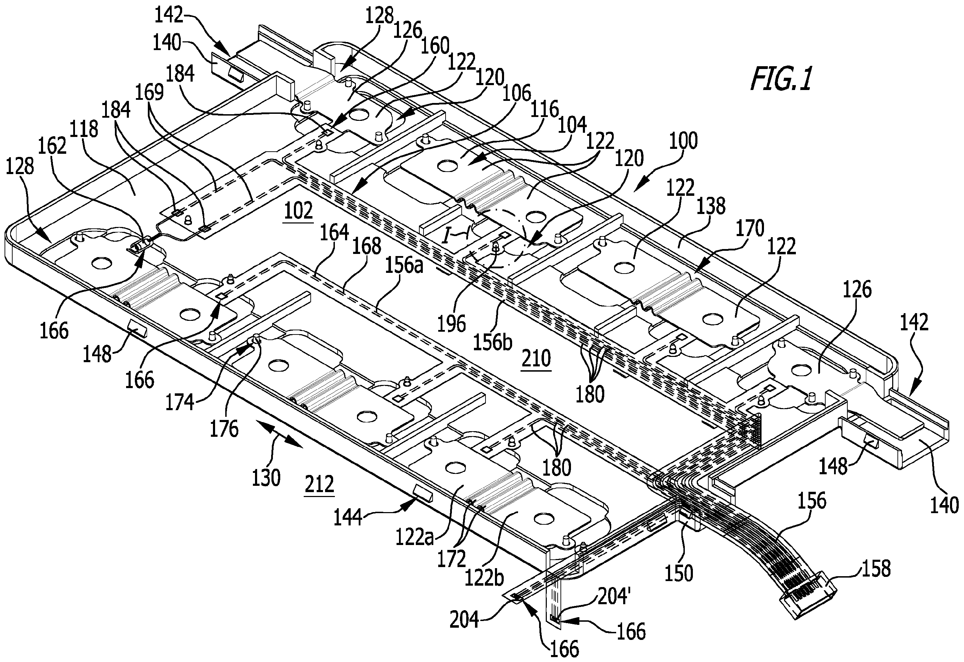

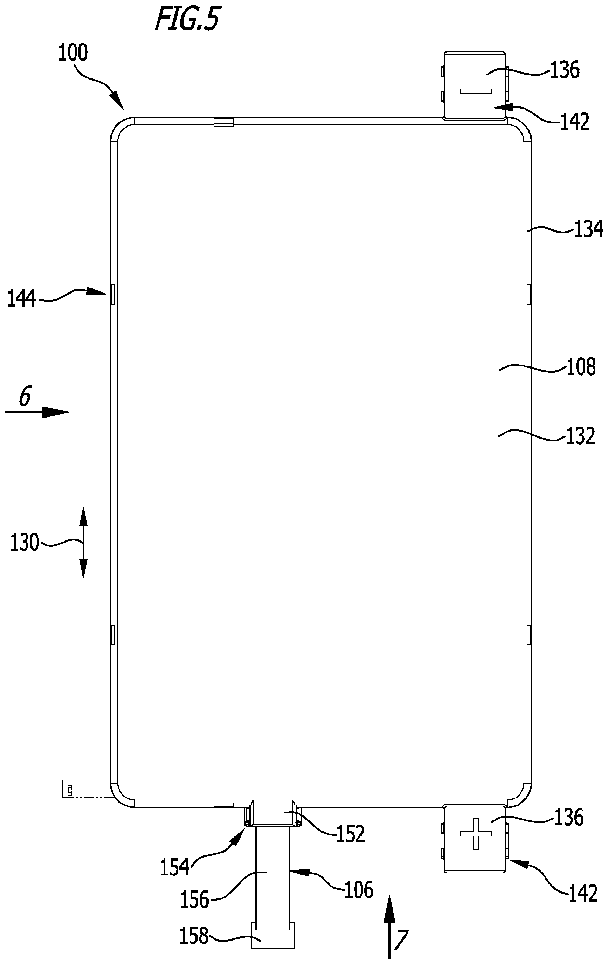

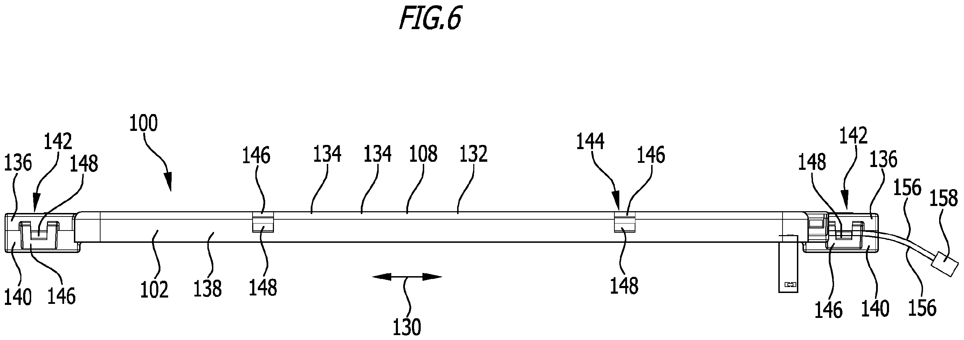

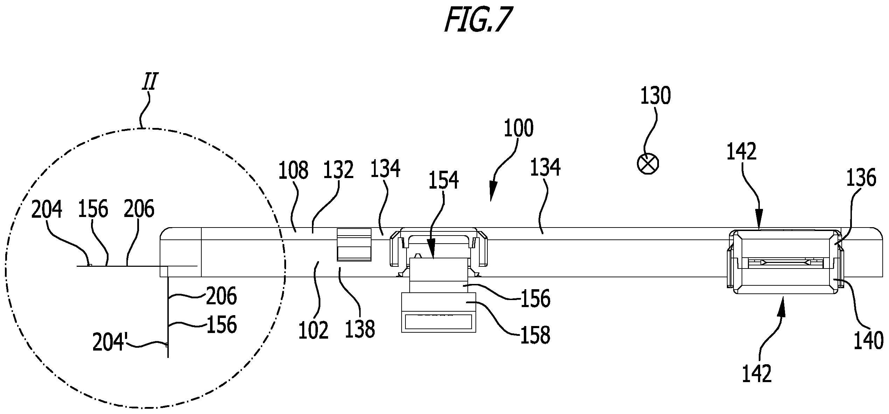

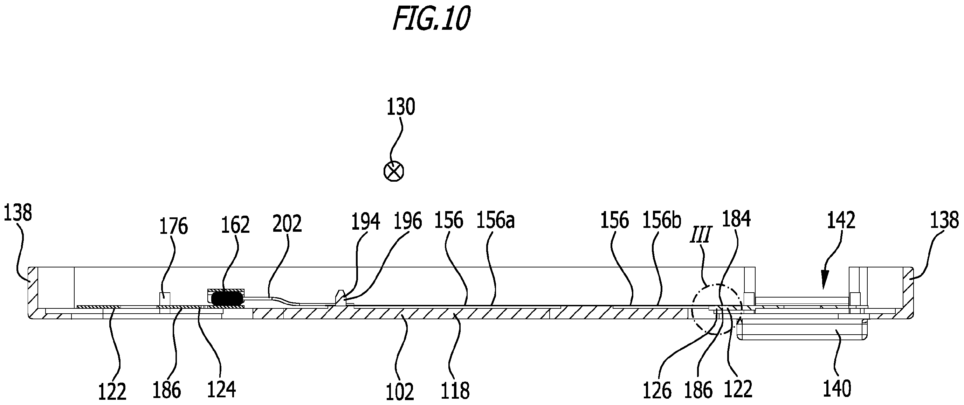

Ein in den Fig. 1 bis 11 dargestelltes, als Ganzes mit 100 bezeichnetes Zellkontaktierungssystem umfasst ein Trägerelement 102, an dem ein Stromleitungssystem 104 und ein Signalleitungssystem 106 gehalten sind, und ein in den Fig. 5 bis 8 dargestelltes, auf das Trägerelement 102 aufsetzbares Abdeckelement 108.

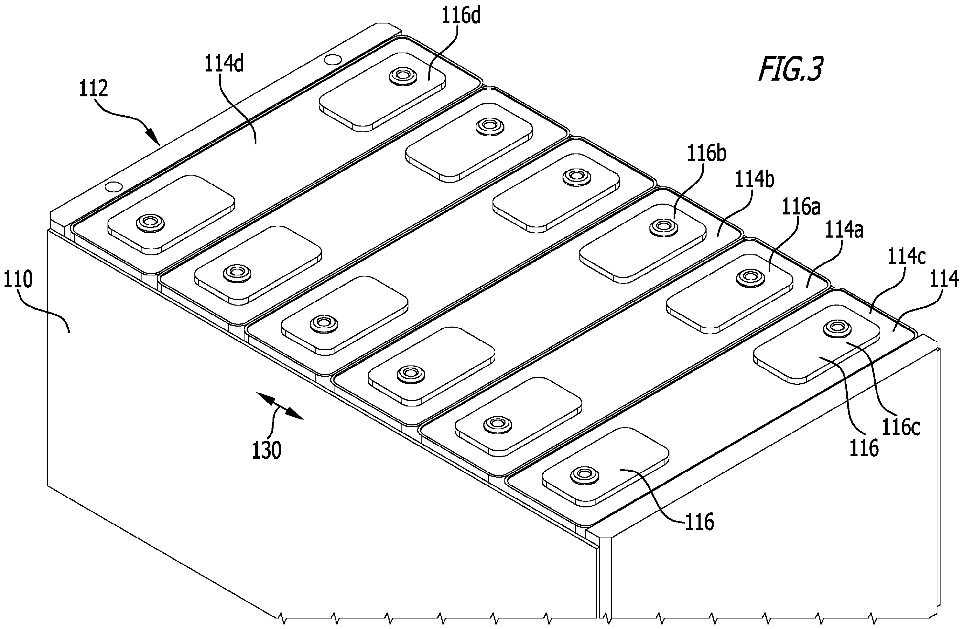

Das Trägerelement 102 ist auf ein (in Fig. 3 dargestelltes) Gehäuse 110 einer elektrochemischen Vorrichtung 112, beispielsweise eines Akkumulatormoduls, mit mehreren elektrochemischen Zellen 114, insbesondere Akkumulatorzellen, aufsetzbar und verschließt im montierten Zustand der elektrochemischen Vorrichtung 112 eine obere Gehäuseöffnung, durch welche Zellterminals 116 der elektrochemischen Zellen 114 der elektrochemischen Vorrichtung 112 hervorstehen.

Das Trägerelement 102 kann beispielsweise in Form einer vorzugsweise im Wesentlichen rechteckigen Trägerplatte 118 ausgebildet sein.

Das Trägerelement 102 ist mit einer Mehrzahl von Durchtrittsöffnungen 120 versehen, wobei jede Durchtrittsöffnung 120 einerseits jeweils einem Kontaktbereich 122 eines Zellverbinders 124 oder eines Stromanschlusses 126 und andererseits jeweils einem Zellterminal 116 der elektrochemischen Zellen 114 der elektrochemischen Vorrichtung 112 zugeordnet ist, so dass durch eine solche Durchtrittsöffnung 120 jeweils ein Zellterminal 116 mit einem zugeordneten Kontaktbereich 122 eines Zellverbinders 124 oder eines Stromanschlusses 126 verbindbar ist.

Dabei kann sich beispielsweise ein Zellterminal 116 durch die Durchtrittsöffnung 120 hindurch erstrecken, um in Kontakt mit einem Kontaktbereich 122 eines Zellverbinders 124 oder eines Stromanschlusses 126 zu kommen.

Alternativ hierzu kann sich auch ein Kontaktbereich 122 eines Zellverbinders 124 oder eines Stromanschlusses 126 durch die jeweils zugeordnete Durchtrittsöffnung 120 hindurch erstrecken, um in Kontakt mit dem jeweils zugeordneten Zellterminal 116 zu kommen.

Ferner ist auch denkbar, dass sich sowohl das Zellterminal 116 als auch der Kontaktbereich 122 des Zellverbinders 124 beziehungsweise des Stromanschlusses 126 beide in die Durchtrittsöffnung 120 hinein erstrecken und dort miteinander verbunden sind.

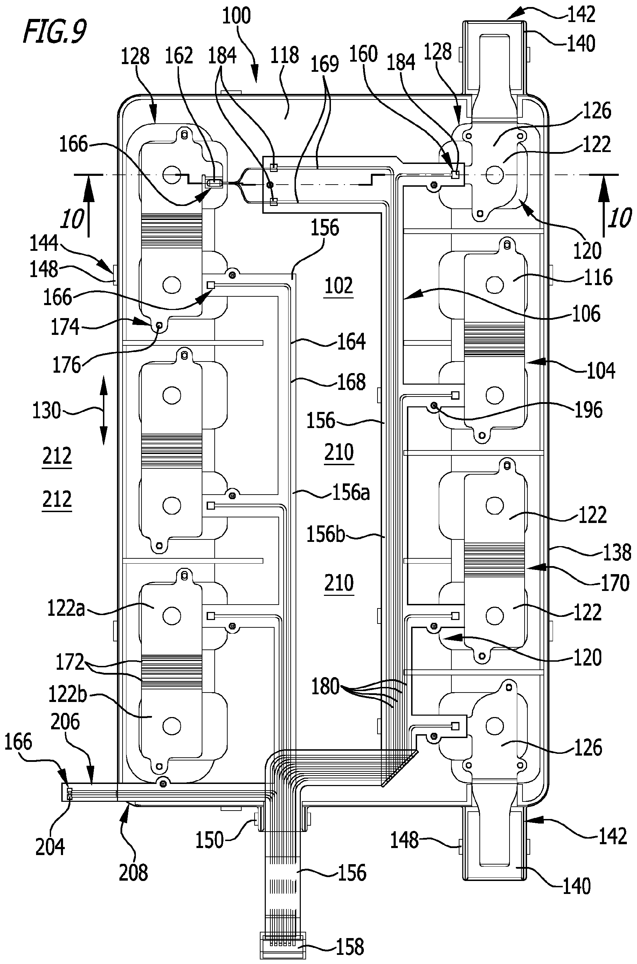

Wie aus den Fig. 1 und 9 zu ersehen ist, können die Durchtrittsöffnungen 120 des Trägerelements 102 in mehreren Reihen 128 angeordnet sein, wobei die Reihen 128 sich beispielsweise in einer Längsrichtung 130 des Trägerelements 102 erstrecken.

An der im montierten Zustand des Zellkontaktierungssystems 100 den elektrochemischen Zellen 114 abgewandten Oberseite des Trägerelements 102 ist das Abdeckelement 108 angeordnet, welches zum Abdecken des Stromleitungssystems 104 und des Signalleitungssystems 106 dient und insbesondere mehrere, vorzugsweise alle, Zellverbinder 124 überdeckt.

Das Abdeckelement 108 ist beispielsweise in Form einer im Wesentlichen rechteckigen Abdeckplatte 132 ausgebildet.

Das Abdeckelement 108 und/oder das Trägerelement 102 umfasst vorzugsweise ein Kunststoffmaterial, insbesondere ein thermoplastisches Material, beispielsweise Polypropylen.

Vorzugsweise ist das Abdeckelement 108 und/oder das Trägerelement 102 im Wesentlichen vollständig aus dem Kunststoffmaterial, insbesondere aus dem thermoplastischen Material, beispielsweise aus Polypropylen, gebildet.

Wie aus den Fig. 5 bis 7 zu ersehen ist, ist das Abdeckelement 108 ferner vorzugsweise mit einem längs eines äußeren Randes umlaufenden, im montierten Zustand des Zellkontaktierungssystems 100 zu dem Trägerelement 102 hin vorstehenden Randbereich 134 versehen.

Der Randbereich 134 des Abdeckelements 108 kann von zwei Durchtrittskanälen 136 unterbrochen sein, welche vom Rand des Abdeckelements 108, beispielsweise in der Längsrichtung 130 nach vorne oder nach hinten, vorstehen und beispielsweise einen im Wesentlichen U-förmigen Querschnitt aufweisen können.

Wie am besten aus Fig. 1 zu ersehen ist, ist auch das Trägerelement 102 vorzugsweise mit einem längs eines äußeren Randes umlaufenden, im montierten Zustand des Zellkontaktierungssystems 100 zu dem Abdeckelement 108 hin vorstehenden Randbereich 138 versehen.

Auch der Randbereich 138 des Trägerelements 102 kann von zwei Durchtrittskanälen 140 unterbrochen sein, welche vom Rand des Trägerelements 102, vorzugsweise in der Längsrichtung 130 nach vorne oder nach hinten, vorstehen und beispielsweise einen im Wesentlichen U-förmigen Querschnitt aufweisen können.

Die Durchtrittskanäle 140 des Trägerelements 102 und die Durchtrittskanäle 136 des Abdeckelements 108 sind an einander entsprechenden Stellen der jeweiligen Randbereiche 138 beziehungsweise 134 angeordnet und mit ihren offenen Seiten einander zugewandt, so dass die Durchtrittskanäle 140, 136 zusammen jeweils einen Durchtrittsschacht 142 bilden, welcher zur Aufnahme jeweils eines der Stromanschlüsse 126 des Zellkontaktierungssystems 100 dient.

Die Stromanschlüsse 126 und die Zellverbinder 124, mittels welcher die Zellterminals 116 jeweils zweier einander benachbarter elektrochemischer Zellen 114 mit unterschiedlicher Polarität elektrisch leitend miteinander verbindbar sind, bilden zusammen das Stromleitungssystem 104 des Zellkontaktierungssystems 100.

Das Stromleitungssystem 104 dient dazu, einen Stromfluss zwischen den elektrochemischen Zellen 114 der elektrochemischen Vorrichtung 112 und zu den oder von den Stromanschlüssen 126 des Zellkontaktierungssystems 100 zu ermöglichen.

Durch dieses Stromleitungssystem 114 werden beispielsweise die elektrochemischen Zellen 114 der elektrochemischen Vorrichtung 112 elektrisch in Reihe geschaltet.

Dabei verbindet jeder Zellverbinder 124 ein erstes Zellterminal 116a negativer Polarität einer ersten elektrochemischen Zelle 114a mit einem zweiten Zellterminal 116b positiver Polarität einer benachbarten zweiten elektrochemischen Zelle 114b (siehe Fig. 3).

Jeweils ein Zellterminal 116c der den Anfang der Zellen-Reihenschaltung der elektrochemischen Vorrichtung 112 bildenden elektrochemischen Zelle 114c und ein Zellterminal 116d der das Ende der Zellen-Reihenschaltung bildenden elektrochemischen Zelle 114d sind elektrisch leitend mit einem der elektrischen leitenden Stromanschlüsse 126 des Zellkontaktierungssystems 100 verbunden.

Mehrere elektrochemische Vorrichtungen 112 mit jeweils einem Zellkontaktierungssystem 100 sind vorzugsweise elektrisch in Reihe geschaltet.

Eine solche Reihenschaltung kann insbesondere dadurch hergestellt werden, dass ein Stromanschluss 126 einer ersten elektrochemischen Vorrichtung 112 mittels eines (nicht dargestellten) Modulverbinders elektrisch leitend mit einem elektrischen Stromanschluss 126 (entgegengesetzter Polarität) einer zweiten elektrochemischen Vorrichtung 112 verbunden wird.

Um das Abdeckelement 108 lösbar an dem Trägerelement 102 festlegen zu können, ist vorzugsweise eine Rastvorrichtung 144 vorgesehen, welche ein oder mehrere an dem Abdeckelement 108 vorgesehene Rastelemente 146 und ein oder mehrere an dem Trägerelement 102 vorgesehene Rastelemente 148 umfasst.

Die abdeckelementseitigen Rastelemente 146 und die trägerelementseitigen Rastelemente 148 sind an einander entsprechenden Stellen des Randbereichs 134 des Abdeckelements 108 beziehungsweise des Randbereichs 138 des Trägerelements 102 angeordnet und verrasten miteinander, wenn das Abdeckelement 108 auf das Trägerelement 102 aufgesetzt wird, so dass das Abdeckelement 108 mittels der Rastvorrichtung 144 lösbar an dem Trägerelement 102 gehalten ist.

Das Trägerelement 102 ist an seinem Randbereich 138 vorzugsweise mit einer Anschlussausnehmung oder mit einem Anschlusskanal 150 versehen, welcher zusammen mit einem zugeordneten Anschlusskanal 152 des Abdeckelements 108 einen Anschlussschacht 154 bildet.

Durch die Anschlussausnehmung oder den Anschlussschacht 154 erstrecken sich flexible Leiterplatten 156 des Signalleitungssystems 106 hindurch.

Die flexiblen Leiterplatten 156 tragen an ihren außerhalb des Trägerelements 102 liegenden Enden einen Signalleitungsanschluss 158 mit mehreren Anschlusspins, der mit einem zum Signalleitungsanschluss 158 komplementären (nicht dargestellten) Signalleitungselement kontaktierbar ist.

Der Signalleitungsanschluss 158 kann beispielsweise als eine Signalleitungsbuchse ausgebildet sein. In diesem Fall ist das komplementär zu dem Signalleitungsanschluss 158 ausgebildete Signalleitungselement vorzugsweise als ein Signalleitungsstecker ausgebildet.

Es kann aber auch vorgesehen sein, dass der Signalleitungsanschluss 158 als ein Signalleitungsstecker und das komplementär zu dem Signalleitungsanschluss 158 ausgebildete Signalleitungselement als eine Signalleitungsbuchse ausgebildet ist.

Der Signalleitungsanschluss 158 dient zum Anschließen des an dem Trägerelement 102 angeordneten Signalleitungssystems 106 an eine (nicht dargestellte) Überwachungseinrichtung der elektrochemischen Vorrichtung 112 über eine (nicht dargestellte), vorzugsweise mehrpolige, Verbindungsleitung.

Das Signalleitungssystem 106 dient zum Verbinden von einer oder mehreren Spannungsabgriffstellen 160 an jeweils einem Zellverbinder 124 oder Stromanschluss 126 und/oder von einem oder mehreren Sensoren, insbesondere Temperatursensoren 162, des Zellkontaktierungssystems 100 mit dem Signalleitungsanschluss 158.

Das Signalleitungssystem 106 umfasst eine oder mehrere Signalleitungen 164, welche jeweils eine Signalquelle 166 elektrisch leitend mit dem Signalleitungsanschluss 158 verbinden.

Wenn die Signalquelle 166 eine Spannungsabgriffstelle 160 an einem Zellverbinder 124 oder an einem Stromanschluss 126 ist, so ist diese Signalquelle 166 über eine Spannungsabgriffsleitung 168 mit dem Signalleitungsanschluss 158 verbunden.

Wenn die Signalquelle 166 ein Temperatursensor 162 ist, so ist die Signalquelle 166 mittels einer oder mehrerer Temperaturmessleitungen 169 elektrisch leitend mit dem Signalleitungsanschluss 158 verbunden.

Die Temperatursensoren 162 können beispielsweise in Kontakt mit einem Kontaktbereich 122 eines Zellverbinders 124 oder eines Stromanschlusses 126 des Zellkontaktierungssystems 100 stehen, um die dort herrschende Temperatur messen zu können.

Jeder der Kontaktbereiche 122 der Zellverbinder 124 und jeder Stromanschluss 126 ist jeweils einem Zellterminal 116 der elektrochemischen Vorrichtung 112 zugeordnet und im montierten Zustand der elektrochemischen Vorrichtung 112 elektrisch leitend, vorzugsweise stoffschlüssig, mit dem jeweils zugeordneten Zellterminal 116 verbunden.

Jeder Zellverbinder 124 umfasst zwei Kontaktbereiche 122 zum elektrischen Kontaktieren von jeweils einem Zellterminal 116 und einen die beiden Kontaktbereiche 122 miteinander verbindenden Kompensationsbereich 170.

Der Kompensationsbereich 170 ist vorzugsweise elastisch und/oder plastisch verformbar, um eine Relativbewegung der beiden Kontaktbereiche 122 des Zellverbinders 124 relativ zueinander im Betrieb der elektrochemischen Vorrichtung und/oder zum Toleranzausgleich bei der Montage des Zellkontaktierungssystems 100 zu ermöglichen.

Zu diesem Zweck kann der Kompensationsbereich 170 insbesondere eine oder mehrere Kompensationswellen 172 aufweisen. Die Kompensationswellen 172 verlaufen vorzugsweise quer, insbesondere im Wesentlichen senkrecht, zu einer Verbindungsrichtung, welche ein Zentrum des ersten Kontaktbereichs 122a und ein Zentrum des zweiten Kontaktbereichs 122b des Zellverbinders 124 miteinander verbindet.

Jeder Kontaktbereich 122 eines Zellverbinders 124 oder eines Stromanschlusses 126 kann mittels jeweils eines Positionierloches 174 an einem jeweils zugeordneten Positionierungsstift 176 des Trägerelements 102 positioniert sein.

Wie bereits erwähnt, umfasst das Signalleitungssystem 106 eine oder mehrere flexible Leiterplatten 156.

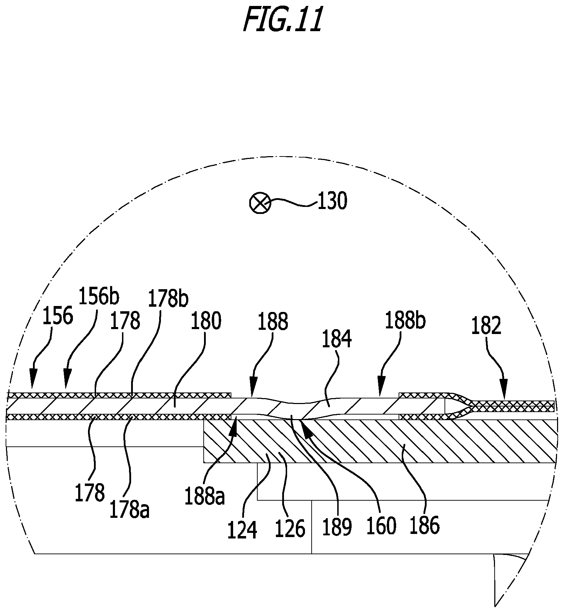

Der Aufbau einer solchen Leiterplatte 156 ist am besten aus der Schnittdarstellung von Fig. 11 zu ersehen.

Jede flexible Leiterplatte 156 umfasst bei diesem Ausführungsbeispiel zwei elektrisch isolierende Isolationsfolien 178, zwischen denen elektrisch leitende Leiterbahnen 180 angeordnet sind.

Die Leiterbahnen 180 bilden die Signalleitungen 164 des Signalleitungssystems 106 und sind vorzugsweise aus einem elektrisch leitenden metallischen Material, beispielsweise aus Kupfer, einer Kupferlegierung, Aluminium oder einer Aluminiumlegierung, gebildet.

Die Leiterbahnen 180 können beispielsweise aus einem Ausgangsmaterial, insbesondere aus einer Leiterfolie, herausgetrennt, beispielsweise ausgestanzt oder ausgeschnitten, sein.

Die Isolationsfolien 178 sind vorzugsweise aus einem elektrisch isolierenden Kunststoffmaterial gebildet.

Die Isolationsfolien 178 sind dünn ausgebildet, um die Flexibilität der daraus gebildeten Leiterplatte 156 nicht zu beeinträchtigen.

Insbesondere kann vorgesehen sein, dass jede Isolationsfolie 178 eine Dicke von weniger als 0,5 mm aufweist.

Jede Isolationsfolie 178 ist vorzugsweise auf der der anderen Isolationsfolie 178 zugewandten Seite mit einer (nicht dargestellten) Klebeschicht versehen, so dass die Isolationsfolie 178 zumindest einseitig klebend ausgebildet ist.

Wie aus Fig. 11 zu ersehen ist, sind die Isolationsfolien 178 dort, wo eine Leiterbahn 180 zwischen den Isolationsfolien 178 angeordnet ist, mit einander gegenüberliegenden Seiten der jeweiligen Leiterbahn 180 verklebt.

In über die Leiterbahnen 180 überstehenden Bereichen sind die Isolationsfolien 178 miteinander verklebt, wie in dem in Fig. 11 mit 182 bezeichneten Bereich.

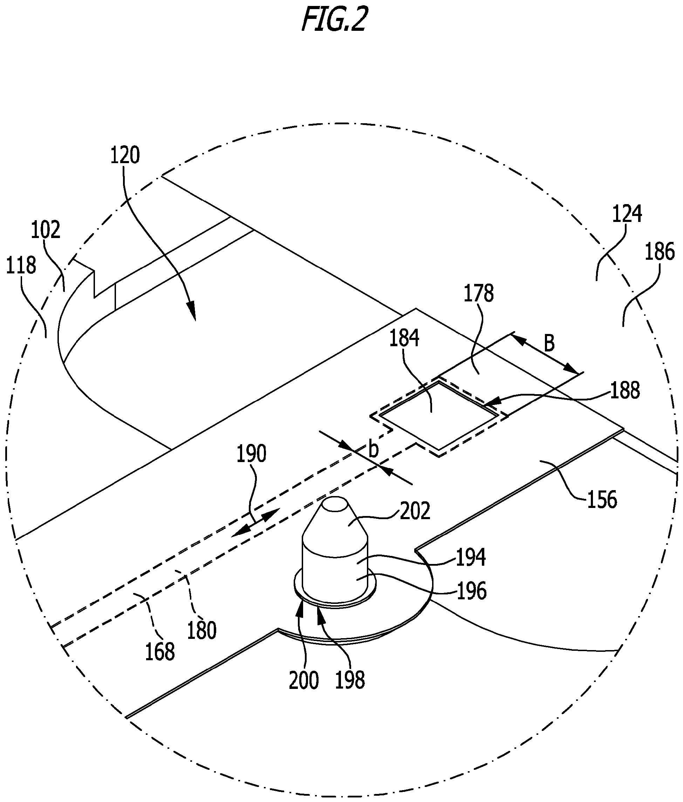

Wie am besten aus den Fig. 2 und 11 zu ersehen ist, umfassen die die Spannungsabgriffsleitungen 168 bildenden Leiterbahnen 180, vorzugsweise in ihrem dem Signalleitungsanschluss 158 abgewandten Endbereich, einen Verbindungsabschnitt 184, an welchem die betreffende Leiterbahn elektrisch leitend mit einem Zellverbinder 124 oder einem Stromanschluss 126 verbunden ist.

Bei der in Fig. 11 dargestellten Ausführungsform ist der Verbindungsabschnitt 184 der Leiterbahn 180 unmittelbar an einem Grundkörper 186 des Zellverbinders 124 oder des Stromanschlusses 126, vorzugsweise stoffschlüssig, festgelegt.

Insbesondere kann vorgesehen sein, dass der Verbindungsabschnitt 184 durch Ultraschweißung, Reibschweißung oder Reibrührschweißung an dem Grundkörper 186 festgelegt ist. Der Verbindungsabschnitt 184 kann daher auch als Schweißpad bezeichnet werden.

Der Grundkörper 186 umfasst vorzugsweise mindestens einen Kontaktbereich 122 des Zellverbinders 124 beziehungsweise des Stromanschlusses 126.

Um den Verbindungsabschnitt 184 der Leiterbahn 180 in Kontakt mit dem Grundkörper 186 bringen zu können, weisen die Isolationsfolien 178 der flexiblen Leiterplatte 156 im Bereich des Verbindungsabschnitts 184 vorzugsweise jeweils ein Fenster 188 auf.

Dabei ist der Verbindungsabschnitt 184 durch das Fenster 188a in der dem Grundkörper 186 zugewandten Isolationsfolie 178a mit dem Grundkörper 186 kontaktierbar.

Durch ein Fenster 188b in der dem Grundkörper 186 abgewandten Isolationsfolie 178b ist der Verbindungsabschnitt 184 mit einem geeigneten Fügewerkzeug, beispielsweise mit einer Sonotrode, kontaktierbar, um den Verbindungsabschnitt 184 der Leiterbahn 180 bei der Montage des Zellkontaktierungssystems 100 mit dem Grundkörper 186 des Zellverbinders 124 oder des Stromanschlusses 126 zu fügen und hierdurch eine elektrisch leitfähige Verbindung zwischen der Leiterbahn 180 und dem Grundkörper 186 herzustellen.

Der Verbindungsabschnitt 184 weist vorzugsweise einen zu dem Grundkörper 186 gerichteten Vorsprung 189 auf, mit dem der Verbindungsabschnitt 184 an dem Grundkörper 186 anliegt und der beispielsweise an dem Verbindungsabschnitt 184 durch einen Umformvorgang, insbesondere einen Prägevorgang, erzeugt sein kann.

Wie aus Fig. 2 zu ersehen ist, weist der Verbindungsabschnitt 184 vorzugsweise eine Breite B, das heißt eine Ausdehnung senkrecht zur Längsrichtung 190 der Leiterbahn 180 und parallel zu den Hauptflächen der Isolationsflächen 178, auf, welche größer ist als die Breite b des an den Verbindungsabschnitt 184 angrenzenden Hauptabschnitts 192 der Leiterbahn 180, das heißt dessen Ausdehnung senkrecht zur Längsrichtung 190 der Leiterbahn 180 und parallel zu den Hauptflächen der Isolationsfolie 178.

Vorzugsweise ist vorgesehen, dass die Breite B des Verbindungsabschnitts 184 mindestens doppelt so groß ist wie die Breite b des Hauptabschnitts 192 der Leiterbahn 180.

Um die flexible Leiterplatte 156 bei der Montage des Zellkontaktierungssystems 100 präzise relativ zu den Zellverbindern 124 und Stromanschlüssen 126 des Stromleitungssystems 104 positionieren zu können, umfasst das Trägerelement 102 trägerelementseitige Positionierelemente 194, beispielsweise in Form von Positionierzapfen 196, die mit jeweils einem signalleitungssystemseitigen Positionierelement 198, beispielsweise in Form eines Positionierloches 200, so zusammenwirken, dass die jeweilige flexible Leiterplatte 156 in einer gewünschten Lage relativ zu dem Trägerelement 102 und damit relativ zu dem an dem Trägerelement 102 gehaltenen Stromleitungssystem 104 positioniert ist.

Um das Einführen eines Positionierzapfens 196 in ein zugeordnetes Positionierloch 200 zu erleichtern, kann der Positionierzapfen 196 mit einer Anfasung 202 versehen sein.

Vorzugsweise sind jedem Verbindungsabschnitt 184 einer Leiterbahn 180 jeweils ein signalleitungssystemseitiges Positionierelement 198 und ein trägerelementseitiges Positionierelement 194 zugeordnet.

Statt durch Verschweißung kann der Verbindungsabschnitt 184 der Leiterbahn 180 auch durch Verlötung an dem Grundkörper 186 des Zellverbinders 124 oder des Stromanschlusses 126 festgelegt sein.

Wie beispielsweise Fig. 1 zu entnehmen ist, kann ein Verbindungsabschnitt 184 einer Leiterbahn 180 statt mit dem Grundkörper 186 eines Zellverbinders 124 oder eines Stromanschlusses 126 auch mit einer Anschlussleitung 202 eines Temperatursensors 162 elektrisch leitend verbunden sein.

Auch diese elektrische Verbindung ist vorzugsweise stoffschlüssig ausgeführt, beispielsweise durch Ultraschweißung, Reibschweißung oder Reibrührschweißung.

Die mit einer Anschlussleitung 202 eines Temperatursensors 162 verbundene Leiterbahn 180 bildet eine Temperaturmessleitung 169 des Signalleitungssystems 106.

Das Signalleitungssystem 106 kann auch einen Sensor 204 aufweisen, der direkt an einer flexiblen Leiterplatte 156 des Signalleitungssystems 106 angeordnet und mit einer oder mehreren Leiterbahnen 180 elektrisch leitend verbunden ist.

Ein solcher Sensor 204 kann beispielsweise als ein Temperatursensor ausgebildet sein.

Ein solcher Temperatursensor kann beispielsweise als ein NTC-Element ausgebildet sein.

Der Sensor 204 kann mit mindestens einer Isolationsfolie 178 der flexiblen Leiterplatte 156 verklebt sein.

Der Sensor 204 kann zumindest teilweise zwischen zwei Isolationsfolien 178 der flexiblen Leiterplatte 156 aufgenommen sein.

Wie aus den Fig. 1 und 9 zu ersehen ist, kann sich ein den Sensor 204 tragender Sensorabschnitt 206 einer flexiblen Leiterplatte 156 des Signalleitungssystems 106 durch eine Durchtrittsöffnung 208 an dem Trägerelement 102, insbesondere an dem Randbereich 138 des Trägerelements 102, hindurch von einem Innenraum 210 des Zellkontaktierungssystems 100 in einen Außenraum 212 des Zellkontaktierungssystems 100 erstrecken.

Der Innenraum 210 des Zellkontaktierungssystems 100 ist dabei der von dem Trägerelement 102 und dem Abdeckelement 108 umschlossene Raum.

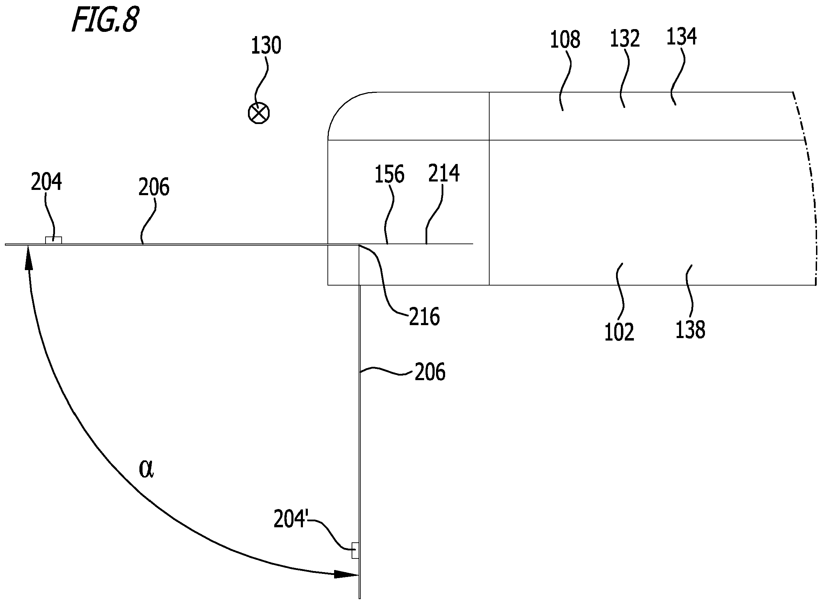

Wie am besten aus Fig. 8 zu ersehen ist, kann der den Sensor 204 tragende Sensorabschnitt 206 der flexiblen Leiterplatte 156 aufgrund der Flexibilität der flexiblen Leiterplatte 156 relativ zu einem vor dem Sensorabschnitt 206 liegenden Zuführabschnitt 214 der flexiblen Leiterplatte 156 um eine Faltlinie 216 so (beispielsweise um einen Winkel α von ungefähr 90°) geschwenkt werden, dass der Sensor 204 durch diese Verformung der flexiblen Leiterplatte 156 von einer ersten Position relativ zu dem Trägerelement 102 (in Fig. 8 mit dem Bezugszeichen 204 bezeichnet) in eine zweite Position relativ zu dem Trägerelement 102 (in Fig. 8 mit dem Bezugszeichen 204' bezeichnet) bewegbar ist.

In der ersten Position ist dabei der Sensor 204 im Außenraum 212 des Zellkontaktierungssystems 100 und außerhalb des Gehäuses 110 der elektrochemischen Vorrichtung 112 angeordnet, während der Sensor 204' in der zweiten Position im montierten Zustand der elektrochemischen Vorrichtung 112 zwischen einer der elektrochemischen Zellen 114 und dem Gehäuse 110 der elektrochemischen Vorrichtung 112 angeordnet ist.

Bei der Montage des Zellkontaktierungssystems 100 an der elektrochemischen Vorrichtung 112 kann somit durch eine einfache Verformung der flexiblen Leiterplatte 156 entschieden werden, an welcher Position der Sensor 204 im Betrieb der elektrochemischen Vorrichtung 112 angeordnet sein soll.

Wenn es sich bei dem Sensor 204 um einen Temperatursensor handelt, kann somit bei der Montage des Zellkontaktierungssystems 100 an der elektrochemischen Vorrichtung 112 entschieden werden, ob eine Temperatur außerhalb der elektrochemischen Vorrichtung 112 oder eine Temperatur im Gehäuse 110 der elektrochemischen Vorrichtung 112 gemessen werden soll.

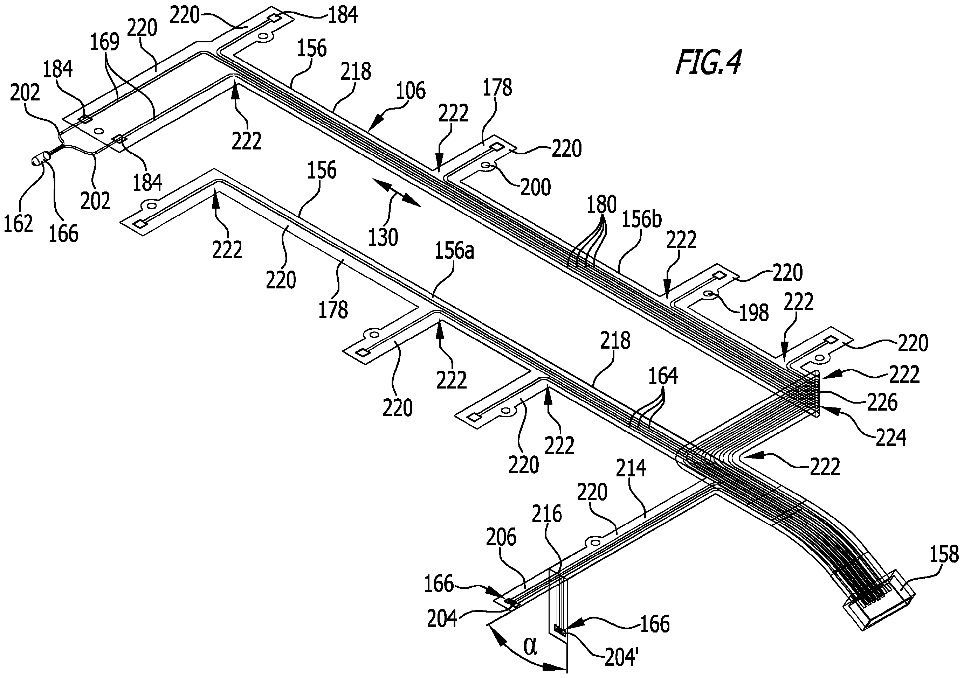

Wie am besten aus Fig. 4 zu ersehen ist, welche das Signalleitungssystem 106 des Zellkontaktierungssystems 100 separat zeigt, kann jede der flexiblen Leiterplatten 156 des Signalleitungssystems 106 einen Hauptabschnitt 218 umfassen, an welchem zu mehreren Signalquellen 166 führende Leiterbahnen 180 angeordnet sind, und von dem Hauptabschnitt 218 abzweigende Nebenabschnitte 220 umfassen, an welchen nur noch jeweils eine Leiterbahn 180 oder mehrere zu derselben Signalquelle 166 führende Leiterbahnen 180 angeordnet sind.

Einer dieser Nebenabschnitte 220 der flexiblen Leiterplatte 156a kann dabei den den Sensor 204 tragenden Sensorabschnitt 206 und den den Sensorabschnitt 206 mit dem Hauptabschnitt 218 verbindenden Zuführabschnitt 214 umfassen.

Jede flexible Leiterplatte 156 kann einen oder mehrere Kurvenbereiche 222 umfassen, an denen sich die Längsrichtung 190 mindestens einer der in dem Kurvenbereich 222 angeordneten Leiterbahnen 180 verändert, vorzugsweise um im Wesentlichen 90°.

An den Kurvenbereichen 222, an denen ein Nebenabschnitt 220 von einem Hauptabschnitt 218 einer flexiblen Leiterplatte 156 abzweigt, ändert sich die Längsrichtung einer Leiterbahn 180 oder mehrerer zu derselben Signalquelle 166 führender Leiterbahnen 180.

In Kurvenbereichen 222, in denen der Hauptabschnitt 218 einer flexiblen Leiterplatte 156 als Ganzes seine Richtung wechselt, ändern sich die Längsrichtungen 190 aller Leiterbahnen 180, welche durch den betreffenden Kurvenbereich 222 verlaufen.

Ein solcher Kurvenbereich kann insbesondere als ein Faltungsbereich 224 ausgebildet sein, in welchem die flexible Leiterplatte 156 (beispielsweise die flexible Leiterplatte 156b) längs einer Faltlinie 226 gefaltet, insbesondere auf sich selbst zurückgefaltet, ist.

Dabei ändert sich die relative Positionierung der Isolationsfolien 178 der flexiblen Leiterplatte 156 bezüglich des Trägerelements 102. Die in dem Abschnitt der flexiblen Leiterplatte 156 zwischen dem Signalleitungsanschluss 158 und dem Faltungsbereich 224 dem Trägerelement 102 zugewandte Isolationsfolie 178 ist in dem nach dem Faltungsbereich 224 liegenden Abschnitt der flexiblen Leiterplatte 156 dem Trägerelement 102 abgewandt, und die in dem zwischen dem Signalleitungsanschluss 158 und dem Faltungsbereich 224 dem Trägerelement 102 abgewandte Isolationsfolie 178 ist in dem nach dem Faltungsbereich 224 liegenden Abschnitt der flexiblen Leiterplatte 156 dem Trägerelement 102 zugewandt.

Durch das Vorsehen eines solchen Faltungsbereichs 224 kann die Außenkontur einer flexiblen Leiterplatte 156 im am Trägerelement 102 montierten Zustand von der Außenkontur abweichen, mit welcher die Isolationsfolien 178 der flexiblen Leiterplatte 156 aus einem Ausgangsmaterial herausgetrennt, insbesondere ausgestanzt oder ausgeschnitten, worden sind.

Hierdurch ist es möglich, den Materialverlust beim Heraustrennen der Isolationsfolien aus dem Ausgangsmaterial zu verringern.

Außerdem weist ein als Faltungsbereich 224 ausgebildeter Kurvenbereich 222 einen kleineren Raumbedarf auf als ein anderer Kurvenbereich 222, in welchem die Leiterbahnen 180, welche den Kurvenbereich 222 durchlaufen, gekrümmt ausgebildet sind.

Das vorstehend beschriebene Zellkontaktierungssystem 100 wird vorzugsweise als eine separate Baugruppe der elektrochemischen Vorrichtung 112 komplett vormontiert.

Zur Herstellung der flexiblen Leiterplatten 156 des Signalleitungssystems 106 werden die Isolationsfolien 178 mit der gewünschten Außenkontur aus einem Ausgangsmaterial herausgetrennt.

Die Leiterbahnen 180 werden ebenfalls mit der gewünschten Außenkontur aus einem Ausgangsmaterial herausgetrennt und auf die Klebeschicht einer der Isolationsfolien 178 aufgelegt.

Anschließend wird die zweite Isolationsfolie 178 mit ihrer Klebeschicht voran auf die Leiterbahnen 180 und die erste Isolationsfolie 178 aufgelegt und mit den Leiterbahnen 180 und der ersten Isolationsfolie 178 verpresst, um eine stoffschlüssige Verbindung herzustellen.

Die Anschlussleitungen 202 eines gegebenenfalls vorhandenen Temperatursensors 162 werden mit den zugeordneten Verbindungsabschnitten 184 von Leiterbahnen 180, vorzugsweise stoffschlüssig, verbunden.

Ein gegebenenfalls vorhandener Sensor 204 wird an die zugeordneten Leiterbahnen 180 angeschlossen und zusammen mit den Leiterbahnen 180 zumindest teilweise zwischen den Isolationsfolien 178 angeordnet. Ein Teil des Sensors 204 kann durch eine Durchtrittsöffnung in einer der Isolationsfolien 178 hindurchtreten.

Die den Verbindungsabschnitten 184 der Leiterbahnen 180 abgewandten Endbereiche der Leiterbahnen 180 werden an Anschlusspins des Signalleitungsanschlusses 158 angeschlossen.

Somit stellen die flexiblen Leiterplatten 156 des Signalleitungssystems 106 und der Signalleitungsanschluss 158, zusammen mit dem Temperatursensor 162 und dem in eine flexible Leiterplatte 156 integrierten Sensor 204, eine als Einheit handhabbare Baugruppe dar.

Die Bestandteile des Stromleitungssystems 104, insbesondere die Zellverbinder 116 und die Stromanschlüsse 118, werden an dem Trägerelement 102 positioniert.

Anschließend wird das Signalleitungssystem 106 an dem Trägerelement 102 positioniert, wobei die signalleitungssystemseitigen Positionierelemente 198 mit den jeweils zugeordneten trägerelementseitigen Positionierelementen 194 zusammenwirken.

Anschließend werden die Spannungsabgriffstellen 160 der Zellverbinder 124 und der Stromanschlüsse 126 elektrisch leitend mit den jeweils zugeordneten Verbindungsabschnitten 184 der Leiterbahnen 180 des Signalleitungssystems 106 verbunden.

Damit sind alle für die Kontaktierung der elektrochemischen Zellen 114 der elektrochemischen Vorrichtung 112 benötigten Bauteile in dem Zellkontaktierungssystem 100 bereits in der erforderlichen relativen Positionierung zusammengefasst.

Das Trägerelement 102 mit dem Stromleitungssystem 104 und dem Signalleitungssystem 106 wird bei der Montage der elektrochemischen Vorrichtung 112 auf das Gehäuse 110 aufgesetzt, in welchem die elektrochemischen Zellen 114 angeordnet sind, und mit dem die Gehäuseöffnung umgebenden Rand des Gehäuses 110 verbunden.

Anschließend werden die Zellverbinder 124 und die Stromanschlüsse 126 elektrisch leitend mit den jeweils zugeordneten Zellterminals 116 der elektrochemischen Vorrichtung 112 kontaktiert, beispielsweise durch Stoffschluss, insbesondere durch Verschweißung, und/oder durch Formschluss.

Nach erfolgter Kontaktierung zwischen dem Stromleitungssystem 104 und den Zellterminals 116 der elektrochemischen Zellen 114 der elektrochemischen Vorrichtung 112 wird das Abdeckelement 108 auf das Trägerelement 102 aufgesetzt und mit demselben, vorzugsweise lösbar, verbunden, insbesondere durch Verrastung, so dass das Abdeckelement 108 das Stromleitungssystem 104 und das Signalleitungssystem 106 des Zellkontaktierungssystems 100 abdeckt und vor einer ungewollten Berührung schützt.

Hierdurch wird eine Beschädigung des Stromleitungssystems 104 und des Signalleitungssystems 106 während des Transports und der Montage der elektrochemischen Vorrichtung 112 verhindert.

Die fertig montierte elektrochemische Vorrichtung 112 kann mit mehreren anderen elektrochemischen Vorrichtungen 112, insbesondere Akkumulatormodulen, zu einer elektrochemischen Vorrichtungsgruppe zusammengesetzt werden, wobei insbesondere verschiedene elektrochemische Vorrichtungen 112 mittels (nicht dargestellter) Modulverbinder, welche die Stromanschlüsse 126 verschiedener elektrochemischer Vorrichtungen 112 miteinander verbinden, zusammengeschaltet werden können.

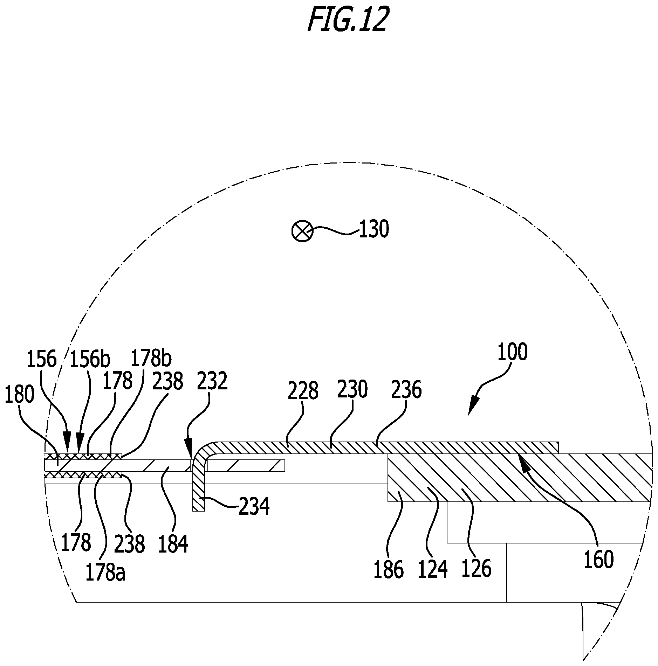

Eine in Fig. 12 ausschnittsweise dargestellte zweite Ausführungsform eines Zellkontaktierungssystems 100 unterscheidet sich von der in den Fig. 1 bis 11 dargestellten ersten Ausführungsform dadurch, dass die Verbindungsabschnitte 184 der Leiterbahnen 180 der flexiblen Leiterplatten 156 nicht unmittelbar an einem Grundkörper 186 des jeweils zugeordneten Zellverbinders 124 oder Stromanschlusses 126 festgelegt sind.

Vielmehr ist bei dieser Ausführungsform mindestens ein Verbindungsabschnitt 184 mittelbar über ein Anschlusselement 228, beispielsweise in Form einer Anschlussfahne 230, elektrisch leitend mit dem jeweils zugeordneten Zellverbinder 124 bzw. Stromanschluss 126 verbunden.

Dabei kann sich das Anschlusselement 228 insbesondere durch eine Durchtrittsöffnung 232 in dem Verbindungsabschnitt 184 hindurch erstrecken.

Die elektrisch leitende Verbindung zwischen dem Verbindungsabschnitt 184 und dem Anschlusselement 228 wird vorzugsweise stoffschlüssig, insbesondere durch Verlötung und/oder Verschweißung, hergestellt.

Die elektrisch leitende Verbindung zwischen dem Anschlusselement 228 und dem Grundkörper 186 des Zellverbinders 124 oder des Stromanschlusses 126 wird vorzugsweise stoffschlüssig, insbesondere durch Verschweißung, beispielsweise durch Ultraschallschweißung, Reibschweißung oder Reibrührschweißung, hergestellt.

Das Anschlusselement 228 kann insbesondere winkelförmig ausgebildet sein, mit einem ersten Schenkel 234, welcher sich durch die Durchtrittsöffnung 232 in dem Verbindungsabschnitt 184 hindurch erstreckt, und mit einem zweiten Schenkel 236, welcher, vorzugsweise flächig, an dem Grundkörper 186 anliegt.

Ferner kann bei dieser Ausführungsform vorgesehen sein, dass der Verbindungsabschnitt 184 seitlich über einen äußeren Rand 238 der Isolationsfolien 178 der flexiblen Leiterplatte 156 übersteht.

Es ist dann nicht erforderlich, an den Isolationsfolien 178 Fenster 188 vorzusehen, um den Verbindungsabschnitt 184 mit dem Anschlusselement 228 fügen zu können.

Im Übrigen stimmt die in Fig. 12 dargestellte zweite Ausführungsform des Zellkontaktierungssystems 100 hinsichtlich Aufbau, Funktion und Herstellungsweise mit der in den Fig. 1 bis 11 dargestellten ersten Ausführungsform überein, auf deren vorstehende Beschreibung insoweit Bezug genommen wird.

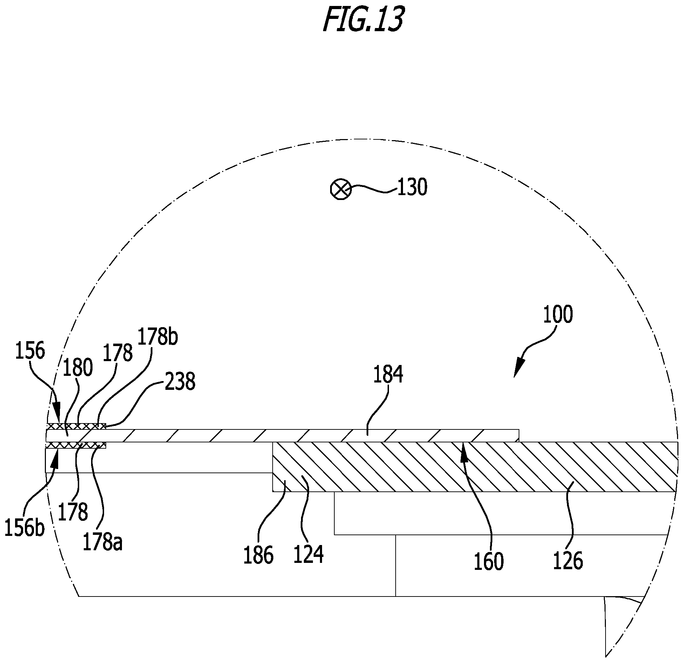

Eine in Fig. 13 ausschnittsweise dargestellte dritte Ausführungsform eines Zellkontaktierungssystems 100 unterscheidet sich von der in den Fig. 1 bis 11 dargestellten ersten Ausführungsform dadurch, dass mindestens ein elektrisch leitend mit einem Zellverbinder 124 oder Stromanschluss 126 des Stromleitungssystems 104 zu verbindender Verbindungsabschnitt 184 einer Leiterbahn 180 einer flexiblen Leiterplatte 156 seitlich über einen äußeren Rand 238 der Isolationsfolien 178 übersteht und in dem überstehenden Bereich, vorzugsweise stoffschlüssig, unmittelbar an einem Grundkörper 186 des Zellverbinders 124 bzw. des Stromanschlusses 126 festgelegt ist, beispielsweise durch Ultraschallschweißung, Reibschweißung oder Reibrührschweißung.

In diesem Fall ist es nicht erforderlich, an den Isolationsfolien 178 Fenster 188 vorzusehen, um den Verbindungsabschnitt 184 mit dem Grundkörper 186 fügen zu können.

Im Übrigen stimmt die in Fig. 13 dargestellte dritte Ausführungsform des Zellkontaktierungssystems 100 hinsichtlich Aufbau, Funktion und Herstellungsweise mit der in den Fig. 1 bis 11 dargestellten ersten Ausführungsform überein, auf deren vorstehende Beschreibung insoweit Bezug genommen wird.

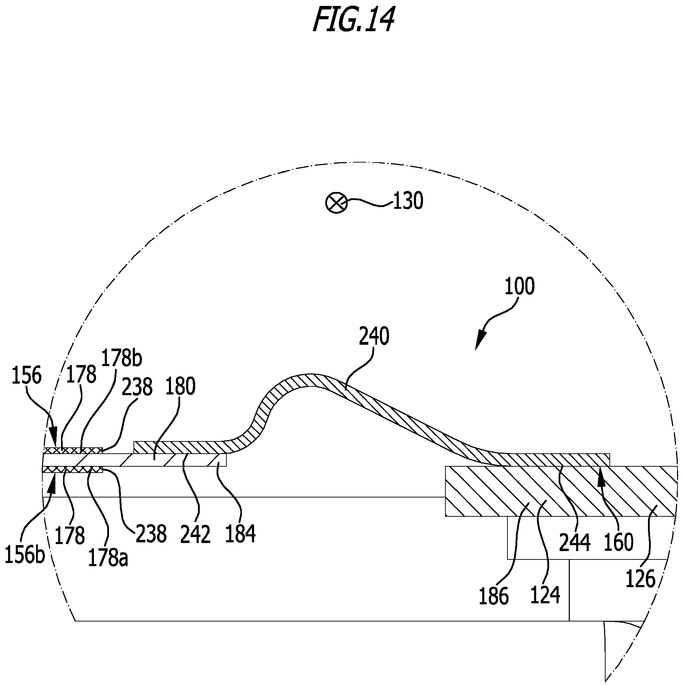

Eine in Fig. 14 ausschnittsweise dargestellte vierte Ausführungsform eines Zellkontaktierungssystems 100 unterscheidet sich von der in den Fig. 1 bis 11 dargestellten ersten Ausführungsform dadurch, dass die Verbindungsabschnitte 184 der Leiterbahnen 180 der flexiblen Leiterplatten 156 nicht unmittelbar an einem Grundkörper 186 eines zugeordneten Zellverbinders 124 oder Stromanschlusses 126 festgelegt sind.

Bei dieser Ausführungsform ist mindestens ein Verbindungsabschnitt 184 einer Leiterbahn 180 mittelbar mittels eines Bondleiters 240 elektrisch leitend mit dem Grundkörper 186 des Zellverbinders 124 bzw. des Stromanschlusses 126 elektrisch leitend verbunden.

Der Bondleiter 240 ist vorzugsweise mittels einer Bondverbindung 242 mit dem Verbindungsabschnitt 184 und vorzugsweise mittels einer weiteren Bondverbindung 244 mit dem Grundkörper 186 verbunden.

Der Bondleiter 240 umfasst vorzugsweise einen Bonddraht.

Der Bonddraht weist vorzugsweise eine Drahtstärke von mindestens 100 µm auf.

Das Material des Bondleiters 240 umfasst vorzugsweise Aluminium, Gold, Platin, Messing und/oder Kupfer.

Insbesondere kann als Material für den Bondleiter 240 eine Aluminiumlegierung oder eine Kupferlegierung verwendet werden.

Ein besonders geeignetes Bonddraht-Material enthält 99,99 Gewichts-% Aluminium.

Der Bondleiter 240 kann blank sein oder mit einer Isolierung versehen sein.

Der Bondleiter 240 kann grundsätzlich jede beliebige Querschnittsform aufweisen.

Vorzugsweise weist der Bondleiter 240 einen im Wesentlichen kreisförmigen oder einen im Wesentlichen rechteckigen Querschnitt auf.

Ferner kann als Material für den Bondleiter 240 auch eine mehrdrahtige Litze verwendet werden.

Zum Herstellen einer Bondverbindung 242, 244 zwischen dem Bondmaterial und dem Bindungspartner wird das Bondmaterial mittels der Bondspitze eines (nicht dargestellten) Bondwerkzeugs mit einem definierten Anpressdruck auf die zu kontaktierende Oberfläche des Bindungspartners gedrückt. Anschließend wird durch die Kombination aus dem Anpressdruck (Bondkraft) und den Ultraschallschwingungen der Bondspitze das Bondmaterial mit dem Material des Bindungspartners, beispielsweise des Verbindungsabschnitts 184 der Leiterbahnen 180 oder des Grundkörpers 186 des Zellverbinders 124 bzw. des Stromanschlusses 128, verschweißt.

Ferner kann auch bei dieser Ausführungsform vorgesehen sein, dass der Verbindungsabschnitt 184 seitlich über einen äußeren Rand 238 der Isolationsfolien 178 der flexiblen Leiterplatte 156 übersteht.

Es ist dann nicht erforderlich, an den Isolationsfolien 178 Fenster 188 vorzusehen, um den Verbindungsabschnitt 184 mit dem Bondleiter 240 fügen zu können.

Im Übrigen stimmt die in Fig. 14 dargestellte vierte Ausführungsform des Zellkontaktierungssystems 100 hinsichtlich Aufbau, Funktion und Herstellungsweise mit der in den Fig. 1 bis 11 dargestellten ersten Ausführungsform überein, auf deren vorstehende Beschreibung insoweit Bezug genommen wird.

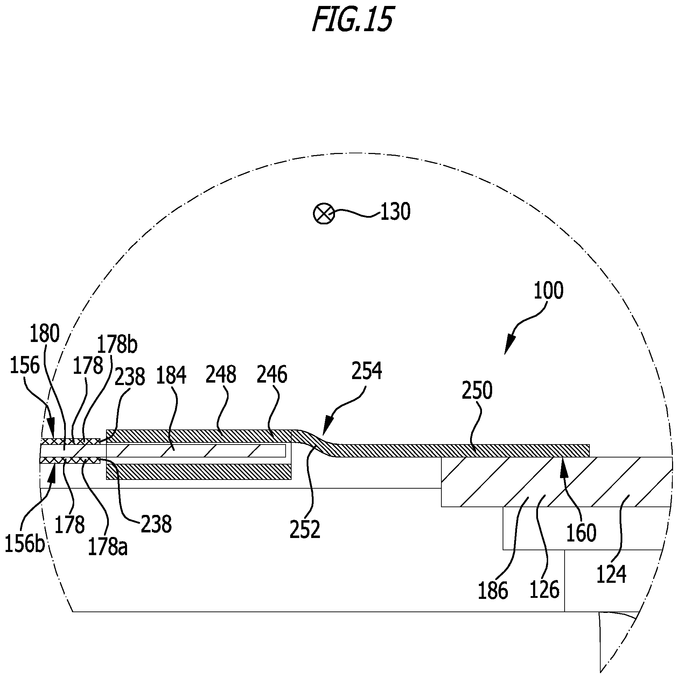

Eine in Fig. 15 ausschnittsweise dargestellte fünfte Ausführungsform eines Zellkontaktierungssystems 100 unterscheidet sich von der in Fig. 14 dargestellten vierten Ausführungsform dadurch, dass der Verbindungsabschnitt 184 mindestens einer Leiterbahn 180 mittels eines Crimpelements 246 elektrisch leitend mit dem Grundkörper 186 eines zugeordneten Zellverbinders 124 oder Stromanschlusses 126 verbunden wird.

Dabei weist das Crimpelement 246 einen in Kontakt mit dem Verbindungsabschnitt 184 stehenden Crimpabschnitt 248 und einen in Kontakt mit dem Grundkörper 186 stehenden Anschlussabschnitt 250 auf.

Der Anschlussabschnitt 250 und der Crimpabschnitt 248 können durch einen Übergangsabschnitt 252 miteinander verbunden sein.

Der Übergangsabschnitt 252 kann eine Abkröpfung 254 aufweisen.

Der Anschlussabschnitt 250 des Crimpelements 246 ist vorzugsweise stoffschlüssig, insbesondere durch Verschweißung, beispielsweise Ultraschallschweißung, Reibschweißung oder Reibrührschweißung, an dem Grundkörper 186 festgelegt.

Der Crimpabschnitt 248 des Crimpelements 246 wird aus einer, beispielsweise im Wesentlichen ebenen, Crimp-Vorform durch einen Umformvorgang so hergestellt, dass er den Verbindungsabschnitt 184 der Leiterbahn 180 einschließt und durch Formschluss und/oder Kraftschluss an dem Verbindungsabschnitt 184 gehalten ist.

Das Material des Crimpelements 246 umfasst vorzugsweise ein elektrisch leitendes metallisches Material, insbesondere Aluminium und/oder Kupfer.

Insbesondere kann als Material für das Crimpelement 246 eine Aluminiumlegierung oder eine Kupferlegierung verwendet werden.

Der Verbindungsabschnitt 184 steht bei dieser Ausführungsform seitlich über einen äußeren Rand 238 der Isolationsfolien 178 der flexiblen Leiterplatte 156 über.

Im Übrigen stimmt die in Fig. 15 dargestellte fünfte Ausführungsform des Zellkontaktierungssystems 100 hinsichtlich Aufbau, Funktion und Herstellungsweise mit der in den Fig. 1 bis 11 dargestellten ersten Ausführungsform überein, auf deren vorstehende Beschreibung insoweit Bezug genommen wird.

## Patentansprüche

1. Zellkontaktierungssystem für eine elektrochemische Vorrichtung (112), die mehrere elektrochemische Zellen (114) umfasst, wobei das Zellkontaktierungssystem (100) ein Signalleitungssystem (106) mit einer oder mehreren Signalleitungen (164) zum elektrisch leitenden Verbinden einer Signalquelle (166) mit einem Signalleitungsanschluss (158) oder mit einer Überwachungseinrichtung der elektrochemischen Vorrichtung (112) umfasst,
wobei das Signalleitungssystem (106) mindestens eine flexible Leiterplatte (156) umfasst,
wobei die flexible Leiterplatte (156) mindestens eine flexible Isolationsfolie (178) und mindestens eine an der Isolationsfolie (178) angeordnete Leiterbahn (180) umfasst,
wobei das Zellkontaktierungssystem (100) ein Trägerelement (102) umfasst, an welchem das Signalleitungssystem (106) angeordnet ist, und wobei das Trägerelement (102) mindestens ein trägerelementseitiges Positionierelement (194) umfasst, das mit einem signalleitungssystemseitigen Positionierelement (198) so zusammenwirkt, dass das Signalleitungssystem (106) in einer gewünschten Lage relativ zu dem Trägerelement (102) positioniert ist,
**dadurch gekennzeichnet,**
**dass** das Trägerelement (102) auf ein Gehäuse (110) der elektrochemischen Vorrichtung (112), in dem mehrere elektrochemische Zellen (114) angeordnet sind, aufsetzbar ist und im montierten Zustand der elektrochemischen Vorrichtung (112) eine obere Gehäuseöffnung, durch welche Zellterminals (116) der elektrochemischen Zellen (114) der elektrochemischen Vorrichtung (112) hervorstehen, verschließt.

2. Zellkontaktierungssystem nach Anspruch 1, **dadurch gekennzeichnet, dass** das Zellkontaktierungssystem (100) mindestens einen Zellverbinder (124) zum elektrisch leitenden Verbinden von Zellterminals (116) verschiedener elektrochemischer Zellen (114) und/oder mindestens einen Stromanschluss (126) zum elektrisch leitenden Verbinden der elektrochemischen Vorrichtung (112) mit einer anderen elektrochemischen Vorrichtung (112) oder mit einem Verbraucher umfasst,
wobei mindestens eine Leiterbahn (180) einen Verbindungsabschnitt (184) umfasst, an welchem die Leiterbahn (180) elektrisch leitend mit einem Zellverbinder (124) oder einem Stromanschluss (126) verbunden ist.

3. Zellkontaktierungssystem nach Anspruch 2, **dadurch gekennzeichnet, dass** der Verbindungsabschnitt (184) unmittelbar an einem Grundkörper (186) des Zellverbinders (124) oder des Stromanschlusses (126) festgelegt ist.

4. Zellkontaktierungssystem nach Anspruch 3, **dadurch gekennzeichnet, dass** der Verbindungsabschnitt (184) durch Ultraschallschweißung, Reibschweißung, Reibrührschweißung oder Verlötung an dem Grundkörper (186) festgelegt ist.

5. Zellkontaktierungssystem nach einem der Ansprüche 2 bis 4, **dadurch gekennzeichnet, dass** der Verbindungsabschnitt (184) über einen äußeren Rand (238) der mindestens einen Isolationsfolie (178) übersteht.

6. Zellkontaktierungssystem nach einem der Ansprüche 2 bis 5, **dadurch gekennzeichnet, dass** die mindestens eine Isolationsfolie (178) im Bereich des Verbindungsabschnitts (184) ein Fenster (188) aufweist, durch welches der Verbindungsabschnitt (184) mit dem Zellverbinder (124) oder dem Stromanschluss (126) oder mit einem Fügewerkzeug kontaktierbar ist.

7. Zellkontaktierungssystem nach einem der Ansprüche 2 bis 6, **dadurch gekennzeichnet, dass** der Verbindungsabschnitt (184) einen zu dem Zellverbinder (124) oder Stromanschluss (126) hin vorstehenden Bereich aufweist.

8. Zellkontaktierungssystem nach einem der Ansprüche 2 bis 7, **dadurch gekennzeichnet, dass** der Verbindungsabschnitt (184) über ein Anschlusselement (228) elektrisch leitend mit dem Zellverbinder (124) oder Stromanschluss (126) verbunden ist.

9. Zellkontaktierungssystem nach einem der Ansprüche 2 bis 8, **dadurch gekennzeichnet, dass** der Verbindungsabschnitt (184) mittels eines Bondleiters (240) elektrisch leitend mit dem Zellverbinder (124) oder Stromanschluss (126) verbunden ist.

10. Zellkontaktierungssystem nach einem der Ansprüche 2 bis 9, **dadurch gekennzeichnet, dass** der Verbindungsabschnitt (184) mittels eines Crimpelements (246) elektrisch leitend mit dem Zellverbinder (124) oder Stromanschluss (126) verbunden ist.

11. Zellkontaktierungssystem nach einem der Ansprüche 1 bis 10, **dadurch gekennzeichnet, dass** die flexible Leiterplatte (156) mindestens zwei flexible Isolationsfolien (178) umfasst, zwischen denen mindestens eine Leiterbahn (180) angeordnet ist.

12. Zellkontaktierungssystem nach einem der Ansprüche 1 bis 11, **dadurch gekennzeichnet, dass** mindestens eine flexible Leiterplatte (156) mindestens eine Faltung aufweist.

13. Zellkontaktierungssystem nach einem der Ansprüche 1 bis 12, **dadurch gekennzeichnet, dass** das Signalleitungssystem (106) einen Sensor (204) aufweist, der an einer flexiblen Leiterplatte (156) des Signalleitungssystems (106) angeordnet ist und mit mindestens einer Leiterbahn (180) der flexiblen Leiterplatte (156) elektrisch leitend verbunden ist.

14. Zellkontaktierungssystem nach Anspruch 13, **dadurch gekennzeichnet, dass** das Zellkontaktierungssystem (100) ein Trägerelement (102) umfasst, an welchem das Signalleitungssystem (106) angeordnet ist, wobei der Sensor (204) durch Verformung der flexiblen Leiterplatte (156) von einer ersten Position relativ zu dem Trägerelement (102) in eine zweite Position relativ zu dem Trägerelement (102) bewegbar ist.

15. Zellkontaktierungssystem nach einem der Ansprüche 13 oder 14, **dadurch gekennzeichnet, dass** das Trägerelement (102) eine Durchtrittsöffnung (208) aufweist, durch welche sich ein den Sensor (204) tragender Sensorabschnitt (206) einer flexiblen Leiterplatte (156) des Signalleitungssystems (106) hindurch erstreckt.

16. Zellkontaktierungssystem nach einem der Ansprüche 13 bis 15, **dadurch gekennzeichnet, dass** der Sensor (204) als ein Temperatursensor ausgebildet ist.

## Claims

1. Cell contact-making system for an electrochemical device (112) that comprises a plurality of electrochemical cells (114), wherein the cell contact-making system (100) comprises a signal conductor system (106) having one or more signal conductors (164) for electrically conductively connecting a signal source (166) to a signal conductor terminal connector (158) or to a monitoring arrangement of the electrochemical device (112), wherein the signal conductor system (106) comprises at least one flexible printed circuit (156),
wherein the flexible printed circuit (156) comprises at least one flexible insulating film (178) and at least one conductor track (180) that is arranged on the insulating film (178),
wherein the cell contact-making system (100) comprises a support element (102) on which the signal conductor system (106) is arranged, and
wherein the support element (102) comprises at least one positioning element (194) on the support element side which cooperates with a positioning element (198) on the signal conductor system side such that the signal conductor system (106) is positioned in a desired location in relation to the support element (102),
**characterized in that**
the support element (102) is placeable on a housing (110) of the electrochemical device (112) in which a plurality of electrochemical cells (114) are arranged and, in the assembled condition of the electrochemical device (112), closes an upper housing opening through which cell terminals (116) of the electrochemical cells (114) of the electrochemical device (112) project.

2. Cell contact-making system according to Claim 1, **characterised in that** the cell contact-making system (100) comprises at least one cell connector (124) for electrically conductively connecting cell terminals (116) of different electrochemical cells (114) and/or at least one current terminal connector (126) for electrically conductively connecting the electrochemical device (112) to another electrochemical device (112) or to a consumer,
wherein at least one conductor track (180) comprises a connection portion (184) at which the conductor track (180) is electrically conductively connected to a cell connector (124) or a current terminal connector (126).

3. Cell contact-making system according to Claim 2, **characterised in that** the connection portion (184) is fixed directly to a base body (186) of the cell connector (124) or current terminal connector (126).

4. Cell contact-making system according to Claim 3, **characterised in that** the connection portion (184) is fixed to the base body (186) by ultrasonic welding, friction welding, friction stir welding or soldering.

5. Cell contact-making system according to any one of Claims 2 to 4, **characterised in that** the connection portion (184) projects beyond an outer edge (238) of the at least one insulating film (178).

6. Cell contact-making system according to any one of Claims 2 to 5, **characterised in that** the at least one insulating film (178) has, in the region of the connection portion (184), a window (188) which is configured for contact to be made therethrough between the connection portion (184) and the cell connector (124) or the current terminal connector (126) or a joining tool.

7. Cell contact-making system according to any one of Claims 2 to 6, **characterised in that** the connection portion (184) has a region that projects towards the cell connector (124) or current terminal connector (126).

8. Cell contact-making system according to any one of Claims 2 to 7, **characterised in that** the connection portion (184) is electrically conductively connected to the cell connector (124) or current terminal connector (126) by way of a terminal connector element (228).

9. Cell contact-making system according to any one of Claims 2 to 8, **characterised in that** the connection portion (184) is electrically conductively connected to the cell connector (124) or current terminal connector (126) by means of a bonding conductor (240).

10. Cell contact-making system according to any one of Claims 2 to 9, **characterised in that** the connection portion (184) is electrically conductively connected to the cell connector (124) or current terminal connector (126) by means of a crimping element (246).

11. Cell contact-making system according to any one of Claims 1 to 10, **characterised in that** the flexible printed circuit (156) comprises at least two flexible insulating films (178) between which at least one conductor track (180) is arranged.

12. Cell contact-making system according to any one of Claims 1 to 11, **characterised in that** at least one flexible printed circuit (156) has at least one fold.

13. Cell contact-making system according to any one of Claims 1 to 12, **characterised in that** the signal conductor system (106) has a sensor (204) which is arranged on a flexible printed circuit (156) of the signal conductor system (106) and is electrically conductively connected to at least one conductor track (180) of the flexible printed circuit (156).

14. Cell contact-making system according to Claim 13, **characterised in that** the cell contact-making system (100) comprises a support element (102) on which the signal conductor system (106) is arranged, wherein the sensor (204) is movable, as a result of deformation of the flexible printed circuit (156), from a first position in relation to the support element (102) into a second position in relation to the support element (102).

15. Cell contact-making system according to either of Claims 13 or 14, **characterised in that** the support element (102) has a passage opening (208) through which there extends a sensor portion (206), carrying the sensor (204), of a flexible printed circuit (156) of the signal conductor system (106).

16. Cell contact-making system according to any one of Claims 13 to 15, **characterised in that** the sensor (204) takes the form of a temperature sensor.

## Revendications

1. Système de mise en contact de cellules pour un dispositif électrochimique (112) qui comprend plusieurs cellules électrochimiques (114), dans lequel le système de mise en contact de cellules (100) comprend un système de lignes de signaux (106) avec une ou plusieurs lignes de signaux (164) pour une liaison électriquement conductrice d'une source de signal (166) avec un raccordement de ligne de signaux (158) ou avec un dispositif de surveillance du dispositif électrochimique (112),
dans lequel le système de lignes de signaux (106) comprend au moins une plaque conductrice (156) flexible,
dans lequel la plaque conductrice (156) flexible comprend au moins un film isolant (178) flexible et au moins une piste conductrice (180) agencée contre le film isolant (178),
dans lequel le système de mise en contact de cellules (100) comprend un élément de support (102) contre lequel le système de lignes de signaux (106) est agencé, et dans lequel l'élément de support (102) comprend au moins un élément de positionnement (194) du côté de l'élément de support, lequel élément de positionnement coopère avec un élément de positionnement (198) du côté du système de lignes de signaux de sorte que le système de lignes de signaux (106) soit positionné dans un emplacement souhaité par rapport à l'élément de support (102),
**caractérisé en ce que**
l'élément de support (102) peut être posé sur un logement (110) du dispositif électrochimique (112), dans lequel logement sont agencées plusieurs cellules électrochimiques (114), et dans l'état monté du dispositif électrochimique (112) ferme un orifice supérieur de logement à travers lequel des terminaux de cellule (116) des cellules électrochimiques (114) du dispositif électrochimique (112) font saillie.

2. Système de mise en contact de cellules selon la revendication 1, **caractérisé en ce que** le système de mise en contact de cellules (100) comprend au moins un connecteur de cellules (124) pour une liaison électriquement conductrice de terminaux de cellule (116) de différentes cellules électrochimiques (114) et/ou au moins un raccordement de courant (126) pour une liaison électriquement conductrice du dispositif électrochimique (112) avec un autre dispositif électrochimique (112) ou avec un utilisateur,
dans lequel au moins une piste conductrice (180) comprend une section de liaison (184) contre laquelle la piste conductrice (180) est reliée de façon électriquement conductrice à un connecteur de cellules (124) ou à un raccordement de courant (126).

3. Système de mise en contact de cellules selon la revendication 2, **caractérisé en ce que** la section de liaison (184) est fixée directement contre un corps de base (186) du connecteur de cellules (124) ou du raccordement de courant (126).

4. Système de mise en contact de cellules selon la revendication 3, **caractérisé en ce que** la section de liaison (184) est fixée contre le corps de base (186) par soudage aux ultrasons, soudage par friction, soudage par friction-malaxage ou brasage.

5. Système de mise en contact de cellules selon l'une des revendications 2 à 4, **caractérisé en ce que** la section de liaison (184) dépasse par-dessus un bord extérieur (238) du au moins un film isolant (178).

6. Système de mise en contact de cellules selon l'une des revendications 2 à 5, **caractérisé en ce que** le au moins un film isolant (178) présente dans la région de la section de liaison (184) une fenêtre (188) à travers laquelle la section de liaison (184) peut être mise en contact avec le connecteur de cellules (124) ou le raccordement de courant (126) ou avec un outil d'assemblage.

7. Système de mise en contact de cellules selon l'une des revendications 2 à 6, **caractérisé en ce que** la section de liaison (184) présente une région faisant saillie en allant vers le connecteur de cellules (124) ou le raccordement de courant (126).

8. Système de mise en contact de cellules selon l'une des revendications 2 à 7, **caractérisé en ce que** la section de liaison (184) est reliée de façon électriquement conductrice au connecteur de cellules (124) ou au raccordement de courant (126) via un élément de raccordement (228).

9. Système de mise en contact de cellules selon l'une des revendications 2 à 8, **caractérisé en ce que** la section de liaison (184) est reliée de façon électriquement conductrice au connecteur de cellules (124) ou au raccordement de courant (126) au moyen d'un conducteur de liaison (240).

10. Système de mise en contact de cellules selon l'une des revendications 2 à 9, **caractérisé en ce que** la section de liaison (184) est reliée de façon électriquement conductrice au connecteur de cellules (124) ou au raccordement de courant (126) au moyen d'un élément serti (246).

11. Système de mise en contact de cellules selon l'une des revendications 1 à 10, **caractérisé en ce que** la plaque conductrice (156) flexible comprend au moins deux films isolants (178) flexibles entre lesquels est agencée au moins une piste conductrice (180).

12. Système de mise en contact de cellules selon l'une des revendications 1 à 11, **caractérisé en ce qu'**au moins une plaque conductrice (156) flexible présente au moins un plissement.

13. Système de mise en contact de cellules selon l'une des revendications 1 à 12, **caractérisé en ce que** le système de lignes de signaux (106) présente un capteur (204) qui est agencé contre une plaque conductrice (156) flexible du système de lignes de signaux (106) et est relié de façon électriquement conductrice à au moins une piste conductrice (180)de la plaque conductrice (156) flexible.

14. Système de mise en contact de cellules selon la revendication 13, **caractérisé en ce que** le système de mise en contact de cellules (100) comprend un élément de support (102) contre lequel le système de lignes de signaux (106) est agencé, dans lequel le capteur (204) peut être déplacé par déformation de la plaque conductrice (156) flexible d'une première position par rapport à l'élément de support (102) à une seconde position par rapport à l'élément de support (102).

15. Système de mise en contact de cellules selon l'une des revendications 13 ou 14, **caractérisé en ce que** l'élément de support (102) présente un orifice de passage (208) à travers lequel s'étend une section de capteur (206), portant le capteur (204), d'une plaque conductrice (156) flexible du système de lignes de signaux (106).

16. Système de mise en contact de cellules selon l'une des revendications 13 à 15, **caractérisé en ce que** le capteur (204) est conçu en tant que capteur de température.
